# EUROPEAN PATENT APPLICATION

(11) **EP 4 669 076 A1**
(43) Date of publication of application: **24.12.2025**
(21) Application number: 24830271.3
(22) Date of filing: 20.05.2024
(51) Int. Cl.: H10K 59/131, H10K 59/12

(54) **DISPLAY SUBSTRATE, MANUFACTURING METHOD THEREFOR, AND DISPLAY APPARATUS**

(30) Priority: 30.06.2023 CN 202310805257
(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: ZHANG, Tiaomei, Beijing 100176 (CN); LIU, Lang, Beijing 100176 (CN)
(74) Representative: Hoffmann Eitle
(86) International application number: PCT/CN2024/094179
(87) International publication number: WO 2025/001623

(57) **Abstract**

A display substrate, a manufacturing method therefor, and a display apparatus. The display substrate comprises a base substrate, a driving circuit layer and a plurality of light-emitting devices. The base substrate comprises a light-emitting area and a non-light-emitting area except for the light-emitting area. The driving circuit layer is located on a side of the base substrate, and the driving circuit layer comprises a plurality of data signal lines, the plurality of data signal lines being located in the non-light-emitting area. The plurality of light-emitting devices are located on the side of the driving circuit layer away from the base substrate, and the plurality of light-emitting devices comprise a first light-emitting device. An anode of the first light-emitting device comprises a plurality of sub-anodes and a connection part, there being a gap between adjacent sub-anodes, and the plurality of sub-anodes in the first light-emitting device all being connected to the connection part. The orthographic projections of the data signal lines on the base substrate do not overlap the orthographic projections of the sub-anodes on the base substrate.

## Description

This application claims priority to Chinese Patent Application No. 202310805257.3, filed on June 30, 2023, which is incorporated herein by reference in its entirety.

### TECHNICAL FIELD

The present disclosure relates to the field of display technologies, and in particular, to a display substrate and a manufacturing method therefor, and a display apparatus.

### BACKGROUND

An organic light-emitting diode (OLED) and a quantum-dot light-emitting diode (QLED) are active light-emitting display devices having advantages of self-luminescence, wide viewing angle, high contrast, low power consumption, extremely high response speed, light weight and small thickness, flexibility and low cost.

At present, with the continuous advancement of display technologies, large-size OLED display apparatuses or large-size QLED display apparatuses are increasingly used in public places such as schools, companies, stations and airports.

### SUMMARY

In an aspect, a display substrate is provided. The display substrate includes a base substrate, a driving circuit layer and a plurality of light-emitting devices. The base substrate includes light-emitting regions and a non-light-emitting region except the light-emitting regions. The driving circuit layer is located on a side of the base substrate. The driving circuit layer includes a plurality of data signal lines, and the plurality of data signal lines are located in the non-light-emitting region. The plurality of light-emitting devices are located on a side of the driving circuit layer away from the base substrate. The plurality of light-emitting devices include first light-emitting devices; an anode of a first light-emitting device includes a plurality of sub-anodes and a connection portion, a gap exists between adjacent sub-anodes, and the plurality of sub-anodes are connected to the connection portion. An orthographic projection of a data signal line on the base substrate is non-overlapping with orthographic projections of the sub-anodes on the base substrate.

In some embodiments, the plurality of light-emitting devices further include second light-emitting devices and third light-emitting devices. A size of a light-emitting region of the first light-emitting device is greater than a size of a light-emitting region of a second light-emitting device, and the size of the light-emitting region of the first light-emitting device is greater than a size of a light-emitting region of a third light-emitting device. A part of the sub-anodes in the first light-emitting device is located on a side of a data signal line coupled to the first light-emitting device, and another part of the sub-anodes in the first light-emitting device is located on another side of the data signal line coupled to the first light-emitting device.

In some embodiments, an orthographic projection of the connection portion on the base substrate partially overlaps with an orthographic projection of the data signal line on the base substrate. An area of the connection portion is less than an area of a single sub-anode.

In some embodiments, in a direction parallel to the base substrate, in the first light-emitting device, an area of a single sub-anode in the part of the sub-anodes is greater than an area of a single sub-anode in the another part of the sub-anodes.

In some embodiments, the driving circuit layer further includes a plurality of repair signal lines. The plurality of repair signal lines are located between the base substrate and the plurality of data signal lines, and the plurality of repair signal lines are located in the non-light-emitting region. An extension direction of the repair signal lines intersects with an extension direction of the data signal lines.

In some embodiments, a part of the sub-anodes in the first light-emitting device is located on a side of a repair signal line, and another part of the sub-anodes in the first light-emitting device is located on another side of the repair signal line.

In some embodiments, the anode of the first light-emitting device includes four sub-anodes and one connection portion, and the connection portion is located among the four sub-anodes in which every two sub-anodes are adjacent. The four sub-anodes include a first sub-anode, a second sub-anode, a third sub-anode, and a fourth sub-anode. A data signal line coupled to the first light-emitting device is located in a gap between the first sub-anode and the second sub-anode that are adjacent in the first light-emitting device and in a gap between the third sub-anode and the fourth sub-anode that are adjacent in the first light-emitting device. The repair signal line is located in a gap between the first sub-anode and the third sub-anode that are adjacent in the first light-emitting device, and in a gap between the second sub-anode and the fourth sub-anode that are adjacent in the first light-emitting device.

In some embodiments, the driving circuit layer further includes a plurality of pixel circuits and a plurality of transition components. A pixel circuit is coupled to the data signal line and a transition component, and the pixel circuit is coupled to a light-emitting device through the transition component. An orthographic projection of the transition component on the base substrate at least partially overlaps with an orthographic projection of a repair signal line on the base substrate.

In some embodiments, the transition component includes a first transition portion and a second transition portion. The first transition portion is coupled to an anode of the light-emitting device, and the second transition portion is coupled to the repair signal line. In a direction perpendicular to an extension direction of the repair signal line, a dimension of the second transition portion is greater than a dimension of the first transition portion.

In some embodiments, patterned shapes of the plurality of transition components coupled to the plurality of light-emitting devices are substantially same.

In some embodiments, the driving circuit layer further includes a plurality of first power supply lines, and the plurality of first power supply lines are located on a side of the transition components close to the plurality of light-emitting devices. A first power supply line is coupled to the pixel circuit, and an orthographic projection of the first power supply line on the base substrate at least partially overlaps with a light-emitting region of the light-emitting device. In the light-emitting region, a surface of the first power supply line close to the light-emitting device is a flat surface; and/or in the light-emitting region, a patterned shape of the first power supply line is substantially symmetrical.

In some embodiments, the orthographic projection of the first power supply line on the base substrate overlaps with a light-emitting region of a second light-emitting device and a light-emitting region of a third light-emitting device.

In some embodiments, the driving circuit layer further includes a plurality of second power supply lines, a plurality of first power supply connection lines, and a plurality of second power supply connection lines. The plurality of second power supply lines are coupled to the plurality of light-emitting devices. The first power supply connection lines extend in a first direction, and the first power supply lines extend in a second direction; and the plurality of first power supply connection lines are connected to the plurality of first power supply lines to form a mesh structure for transmitting a first power supply signal. The first direction and the second direction intersect each other. The second power supply connection lines extend in the first direction, and the second power supply lines extend in the second direction; and the plurality of second power supply connection lines are connected to the plurality of second power supply lines to form a mesh structure for transmitting a second power supply signal.

In some embodiments, in a light-emitting region of at least one light-emitting device, a surface of the driving circuit layer close to the light-emitting device is a flat surface.

In some embodiments, in a light-emitting region of at least one light-emitting device, a patterned shape of a surface of the driving circuit layer close to the light-emitting device is substantially symmetrical.

In some embodiments, the driving circuit layer further includes filling blocks. A filling block is located between a data signal line coupled to the first light-emitting device and the first power supply line, and an extension direction of the filling block is substantially parallel to an extension direction of the data signal line. An orthographic projection of the filling block on the base substrate partially overlaps with an orthographic projection of a portion of the anode of the first light-emitting device on the base substrate. The orthographic projection of the first power supply line on the base substrate partially overlaps with an orthographic projection of another portion of the anode of the first light-emitting device on the base substrate.

In the light-emitting region, a surface of the filling block close to the light-emitting device is a flat surface; and/or in the light-emitting region, a patterned shape of the filling block is substantially symmetrical.

In some embodiments, the display substrate further includes a pixel defining layer. The pixel defining layer is located on the side of the driving circuit layer away from the base substrate, and the pixel defining layer includes a plurality of light-emitting openings. The plurality of light-emitting devices cover the plurality of light-emitting openings, respectively. A light-emitting opening of the first light-emitting device includes a plurality of light-emitting sub-openings, and orthographic projections of the plurality of sub-anodes in the first light-emitting device on the base substrate cover orthographic projections of contours of the plurality of light-emitting sub-openings on the base substrate, respectively. An orthographic projection of the pixel defining layer on the base substrate covers an orthographic projection of the connection portion of the first light-emitting device on the base substrate.

In some embodiments, the driving circuit layer further includes a plurality of enable signal lines, and the plurality of enable signal lines are coupled to the plurality of light-emitting devices. An orthographic projection of an enable signal line coupled to a light-emitting device on the base substrate is non-overlapping with the orthographic projections of the sub-anodes on the base substrate.

In another aspect, a manufacturing method for a display substrate is provided. The manufacturing method for the display substrate includes: providing a base substrate, the base substrate including light-emitting regions and a non-light-emitting region except the light-emitting regions; forming a driving circuit layer on the base substrate, the driving circuit layer including a plurality of data signal lines located in the non-light-emitting region; and forming a plurality of light-emitting devices on a side of the driving circuit layer away from the base substrate. The plurality of light-emitting devices include first light-emitting devices; an anode of a first light-emitting device includes a plurality of sub-anodes and a connection portion, a gap exists between adjacent sub-anodes, and the plurality of sub-anodes are connected to the connection portion. An orthographic projection of a data signal line on the base substrate is non-overlapping with orthographic projections of the sub-anodes on the base substrate.

In yet another aspect, a display apparatus is provided. The display apparatus includes a circuit board and the display substrate as described in any of the above embodiments, and the display substrate is located on a side of the circuit board and is coupled to the circuit board.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to those drawings. In addition, the accompanying drawings in the following description can be regarded as schematic diagrams, but are not limitations on actual sizes of products, actual processes of methods and actual timings of signals involved in the embodiments of the present disclosure.
FIG. 1 is a structural diagram of a display apparatus, in accordance with some embodiments;
FIG. 2 is a perspective view of a display substrate, in accordance with some embodiments;
FIG. 3 is a sectional view of the display substrate in FIG. 2 taken along the line A-A', in accordance with some embodiments;
FIG. 4 is an equivalent circuit diagram of a pixel circuit in a display substrate, in accordance with some embodiments;
FIG. 5 is a sectional view of a base substrate and a driving circuit layer in a display substrate, in accordance with some embodiments;
FIG. 6 is a structural diagram of a semiconductor layer in a display substrate, in accordance with some embodiments;
FIG. 7 is a structural diagram of a first conductive layer in a display substrate, in accordance with some embodiments;
FIG. 8 is a structural diagram of a second conductive layer in a display substrate, in accordance with some embodiments;
FIG. 9 is a structural diagram of a third conductive layer in a display substrate, in accordance with some embodiments;
FIG. 10 is a structural diagram of a fourth conductive layer in a display substrate, in accordance with some embodiments;
FIG. 11 is a structural diagram of anodes of light-emitting devices in a display substrate, in accordance with some embodiments;
FIG. 12 is a structural diagram of pixel circuits and anodes in a display substrate, in accordance with some embodiments;
FIG. 13 is a structural diagram of a fourth conductive layer and sub-anodes in a display substrate, in accordance with some embodiments;
FIGS. 14A to 14C are structural diagrams showing a pixel circuit and an anode in a display substrate, in accordance with some embodiments; and
FIGS. 15 to 17 are flowcharts of a manufacturing method for a display substrate, in accordance with some embodiments.

### DETAILED DESCRIPTION

The technical solutions in some embodiments of the present disclosure will be described clearly and completely with reference to the accompanying drawings. Obviously, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

The terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. In the description of the embodiments of the present disclosure, the term "a/the plurality of" means two or more unless otherwise specified.

In the description of some embodiments, the expressions "coupled", "connected", and derivatives thereof can be used. The term "connected" should be understood in a broad sense. For example, the term "connected" may represent a fixed connection, a detachable connection, or a one-piece connection, or may represent a direct connection, or may represent an indirect connection through an intermediate medium. The term "coupled" indicates, for example, that two or more components are in direct physical or electrical contact with each other. The term "coupled" or "communicatively coupled" may also mean that two or more components are not in direct contact with each other but still cooperate or interact with each other. The embodiments disclosed herein are not necessarily limited to the content herein.

The phrase "at least one of A, B, and C" has the same meaning as the phrase "at least one of A, B, or C", and they both include the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

As used herein, the term "if" is, optionally, construed as "when" or "in a case where" or "in response to determining" or "in response to detecting", depending on the context. Similarly, depending on the context, the phrase "if it is determined that" or "if [a stated condition or event] is detected" is optionally construed as "in a case where it is determined that" or "in response to determining that" or "in a case where [the stated condition or event] is detected" or "in response to detecting [the stated condition or event]".

The phrase "applicable to" or "configured to" used herein means an open and inclusive expression, which does not exclude devices that are applicable to or configured to perform additional tasks or steps.

In addition, the phase "based on" used herein is meant to be open and inclusive, since a process, step, calculation or other action that is "based on" one or more of the stated conditions or values may, in practice, be based on an additional condition or value beyond those stated.

The term such as "about", "substantially", or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular", or "equal" as used herein includes a stated condition and a condition similar to the stated condition. A range of the similar condition is within an acceptable range of deviation, and the acceptable range of deviation is determined by a person of ordinary skill in the art, considering measurement in question and errors associated with measurement of a particular quantity (i.e., the limitations of a measurement system). For example, the term "parallel" includes absolute parallelism and approximate parallelism, and an acceptable range of deviation of the approximate parallelism may be a deviation within 5°; and the term "perpendicular" includes absolute perpendicularity and approximate perpendicularity, and an acceptable range of deviation of the approximate perpendicularity may also be a deviation within 5°. The term "equal" includes absolute equality and approximate equality, and an acceptable range of deviation of the approximate equality may be, for example, that a difference between two equals is less than or equal to 5% of either of the two equals.

It should be understood that, when a layer or element is referred to as being on another layer or substrate, it may be that the layer or element is directly on the another layer or substrate, or it may be that intervening layer(s) exist between the layer or element and the another layer or substrate.

In addition, as used herein, "potential of a signal is an effective potential" means that the potential of the signal is capable of controlling a transistor to be in an on state. For example, a gate of a transistor receives a signal of an effective potential, so that the transistor is in an on state. As used herein, "potential of a signal is an invalid potential" means that the potential of the signal is capable of controlling a transistor to be in an off state. For example, a gate of a transistor receives a signal of an invalid potential, so that the transistor is in an off state.

It should be noted that transistors used in a pixel circuit provided in the embodiments of the present disclosure can be thin film transistors, field effect transistors or other switching devices with same characteristics, and the transistors in the present disclosure can be enhancement-mode transistors or depletion-mode transistors, which will not be limited in the present disclosure.

A control electrode of each transistor used in the pixel circuit is a gate of the transistor, a first electrode of the transistor is one of a source and a drain of the transistor, and a second electrode of the transistor is another of the source and the drain of the transistor. Since the source and the drain of the transistor may be symmetrical in structure, the source and the drain thereof may be indistinguishable in structure. That is, there may be no difference in structure between the first electrode and the second electrode of the transistor in the embodiments of the present disclosure. For example, in a case where the transistor is a P-type transistor, the first electrode of the transistor is the source, and the second electrode of the transistor is the drain. For example, in a case where the transistor is an N-type transistor, the first electrode of the transistor is the drain, and the second electrode of the transistor is the source.

It should also be noted that the high potential signal and the low potential signal mentioned in the present disclosure are relatively high and low, that is, it only means that the potential of the high potential signal is higher than the potential of the low potential signal, and the specific potential values of the high potential and the low potential are not limited.

Exemplary embodiments are described herein with reference to sectional views and/or plan views as idealized exemplary drawings. In the drawings, thicknesses of layers and sizes of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in a device, and are not intended to limit the scope of the exemplary embodiments.

Currently, in a direction perpendicular to a display substrate, data signal lines and anodes of light-emitting devices are provided in sequence in a direction away from a base substrate. The data signal lines are arranged in a light-emitting region of the light-emitting devices. The data signal lines are coupled to the light-emitting devices. The light-emitting devices include red light-emitting devices, green light-emitting devices and blue light-emitting devices. An area of an anode of the blue light-emitting device is larger than an area of an anode of the red light-emitting device, and the area of the anode of the blue light-emitting device is also greater than an area of an anode of the green light-emitting device.

However, the inventors of the present disclosure have discovered through research that in the current display substrate, the data signal lines are arranged in the light-emitting region of the light-emitting devices, which results in formation of parasitic capacitors between the anodes of the light-emitting devices and the data signal lines. Two electrode plates of the parasitic capacitor are overlapping portions of the anode of the light-emitting device and the data signal line. Compared with the red light-emitting device and green light-emitting device, the area of the anode of the blue light-emitting device is larger, which makes the parasitic capacitance between the anode of the blue light-emitting device and the data signal line larger, resulting in a poor stability of the operating voltage of the blue light-emitting device and a poor charging effect of the blue light-emitting device, and reducing a display effect of the display substrate. Moreover, there are a large number of light-emitting devices in a large-size display substrate, and a probability of damage to the light-emitting devices during the manufacturing process of the display substrate is high, which reduces the production yield of the display substrate. In addition, in the large-size display substrate, since the area of the anode of the light-emitting device is large, the anode flatness of the light-emitting device is poor. Thus, it easily causes the light-emitting device to tilt, resulting in a light-exit direction of the light-emitting device tilting towards a non-light-emitting region; and it also causes the poor display effect of the display substrate.

In light of this, embodiments of the present disclosure provide a display substrate and a manufacturing method therefor, and a display apparatus to solve the above problems, which will be introduced below.

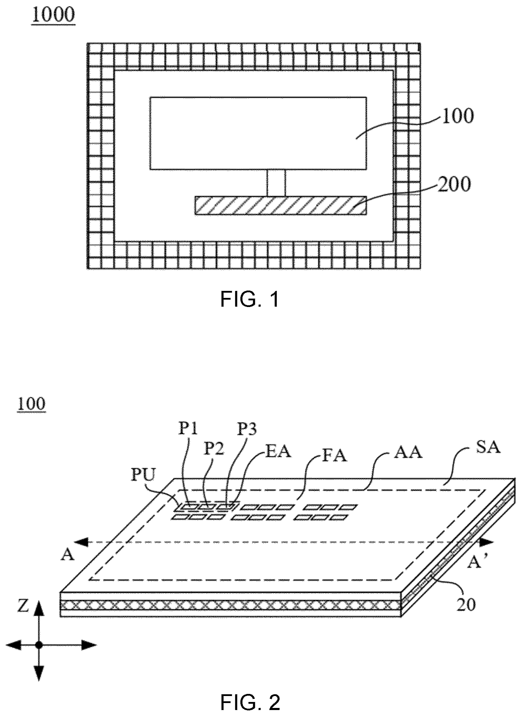

FIG. 1 is a structural diagram of a display apparatus, in accordance with some embodiments.

Referring to FIG. 1, some embodiments of the present disclosure provide a display apparatus 1000. The display apparatus 1000 can be used for displaying static or dynamic images. For example, the display apparatus 1000 is an OLED display apparatus, a Mini LED display apparatus or a Micro LED display apparatus. For example, the display apparatus 1000 is a small and medium sized display apparatus such as a tablet computer, a smart phone, a head-mounted display, an automobile navigation unit, a camera, a central information display (CID) provided in a vehicle, a wristwatch-type display apparatus or any other wearable device, a personal digital assistant (PDA), a portable multimedia player (PMP), or a game console, or is a medium and large sized electronic apparatus such as a television, an external billboard, a monitor, a home appliance including a display screen, a personal computer, or a laptop computer. The electronic apparatus described above may represent an example for applying the display apparatus 1000, so that a person of ordinary skill in the art can recognize that the display apparatus 1000 may also be any other electronic apparatus without departing from the spirit and scope of the present disclosure.

As shown in FIG. 1, the display apparatus 1000 can include a display substrate 100 and a circuit board 200, and the display substrate 100 is coupled to the circuit board 200. The circuit board 200 can be located on a backlight side (i.e., a side opposite to a display side of the display substrate 100) of the display substrate 100. For example, the circuit board 200 is a flexible printed circuit board (FPC) or a printed circuit board 200. The circuit board 200 can provide light-emitting data signals, and the display substrate 100 emits light based on the light-emitting data signals provided by the circuit board 200.

FIG. 2 is a perspective view of a display substrate, in accordance with some embodiments.

Referring to FIG. 2, some embodiments of the present disclosure provide a display substrate 100. The display substrate 100 is a display component capable of emitting display light. The display substrate 100 can emit monochromatic light (light of a single color) or colored light. The display substrate 100 may be applied to the display apparatus 1000.

As shown in FIG. 2, the display substrate 100 includes a display area AA for displaying images and a non-display area SA that does not display images. The display area AA includes light-emitting regions EA and a non-light-emitting region FA except the light-emitting regions EA. The non-display area SA is located on at least one side of the display area AA. In some examples, the non-display area SA encircles the display area AA, or is located outside the display area AA in at least one direction.

For example, a shape of the display substrate 100 in a plan view includes a rectangle, a circle, an ellipse, a rhombus, a trapezoid, a square or any other shape according to display needs.

For example, the display substrate 100 is an OLED display substrate, a QLED display substrate, or a micro light-emitting diode (Micro LED) display substrate, which is not limited in the present disclosure.

The following embodiments of the present disclosure are all described by considering an example in which the display substrate 100 is the OLED display substrate, but it should not be considered as being limited to the OLED display substrate.

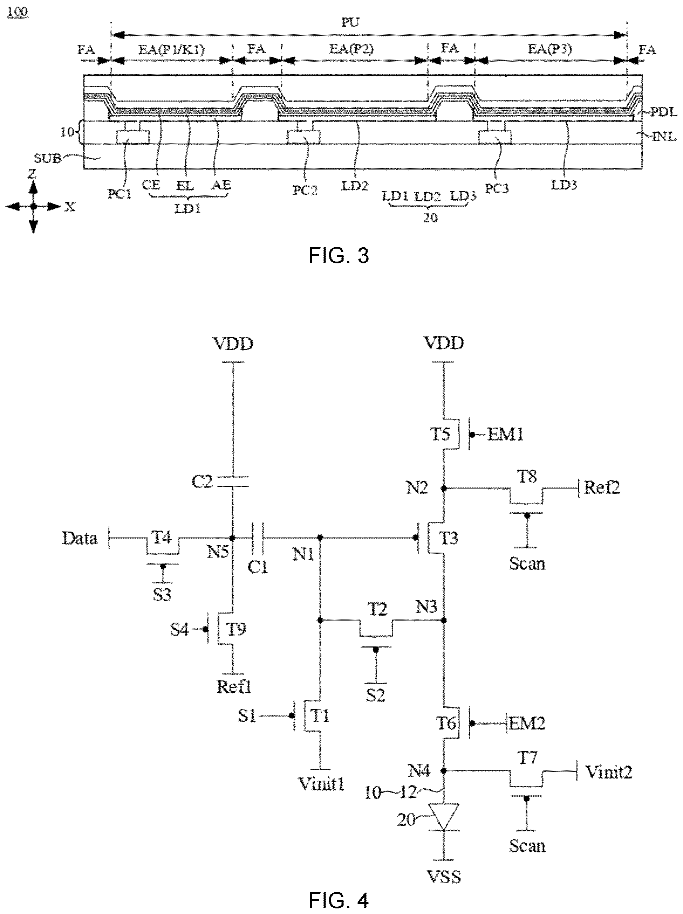

FIG. 3 is a sectional view of the display substrate in FIG. 2 taken along the line A-A', in accordance with some embodiments.

Referring to FIG. 3, the display substrate 100 can include a base substrate SUB, a driving circuit layer 10 and a plurality of light-emitting devices 20. The driving circuit layer 10 is located on a side of the base substrate SUB, and the plurality of light-emitting devices 20 are located on a side of the driving circuit layer 10 away from the base substrate SUB. The driving circuit layer 10 is coupled to the plurality of light-emitting devices 20, and can control and drive the plurality of light-emitting devices 20 to emit light.

The base substrate SUB can be a flexible base substrate SUB or a rigid base substrate SUB. The rigid base substrate SUB may include glass or quartz. The flexible base substrate SUB may include polyethylene terephthalate (PET), polyimide (PI), or cyclo olefin polymer (COP).

The base substrate SUB can include a plurality of pixel unit regions PU that are repeatedly arranged. Each pixel unit region PU can include multiple light-emitting regions EA and multiple non-light-emitting regions FA.

In some examples, as shown in FIGS. 2 and 3, the multiple light-emitting regions EA in each pixel unit region PU includes a first sub-pixel region P1, a second sub-pixel region P2 and a third sub-pixel region P3 that display different colors. For example, the first sub-pixel region P1 is configured to display blue light, the second sub-pixel region P2 is configured to display green light, and the third sub-pixel region P3 is configured to display red light.

The non-light-emitting region FA may be located between the first sub-pixel region P1 and the second sub-pixel region P2, between the second sub-pixel region P2 and the third sub-pixel region P3, and between the third sub-pixel region P3 and the first sub-pixel region P1.

In some other examples, each pixel unit region PU includes one first sub-pixel region P1, two second sub-pixel regions P2 and one third sub-pixel region P3. The one first sub-pixel region P1, the two second sub-pixel regions P2 and the one third sub-pixel region P3 are arranged at intervals, and they are repeatedly arranged. In this case, the non-light-emitting region FA may also be located between the two second sub-pixel regions P2.

As shown in FIG. 3, the driving circuit layer 10 can include a plurality of pixel circuits. In a single pixel unit region PU, a first pixel circuit PC1, a second pixel circuit PC2 and a third pixel circuit PC3 can be included. For example, the first pixel circuit PC1 is located in the first sub-pixel region P1, the second pixel circuit PC2 is located in the second sub-pixel region P2, and the third pixel circuit PC3 is located in the third sub-pixel region P3. For another example, thin film transistor(s) in at least one of the first pixel circuit PC1, the second pixel circuit PC2 and the third pixel circuit PC3 may be located in the non-light-emitting region FA located between sub-pixel regions.

The specific structure of the pixel circuit is not limited. For example, the pixel circuit has a structure of 2T1C, 3T1C, 4T1C, 7T1C, 7T2C, 8T1C, 9T1C, or 9T2C. The number before "T" is the number of transistors in the pixel circuit, and the number before "C" is the number of capacitors in the pixel circuit.

The transistor(s) in at least one of the first pixel circuit PC1, the second pixel circuit PC2 and the third pixel circuit PC3 may be thin film transistor(s) including polysilicon or thin film transistor(s) including oxide semiconductor. For example, in the case where the thin film transistor is the thin film transistor including the oxide semiconductor, the transistor has a top-gate thin film transistor structure.

FIG. 4 is an equivalent circuit diagram of a pixel circuit in a display substrate, in accordance with some embodiments.

In some embodiments, as shown in FIG. 4, the pixel circuit is of a structure of 9T2C, and the pixel circuit includes a first transistor T1, a second transistor T2, a third transistor T3, a fourth transistor T4, a fifth transistor T5, a sixth transistor T6, a seventh transistor T7, an eighth transistor T8, a ninth transistor T9, a first capacitor C1, and a second capacitor C2. The pixel circuit can further include a first node N1, a second node N2, a third node N3, a fourth node N4, and a fifth node N5.

The driving circuit layer 10 can include a plurality of signal lines. The plurality of signal lines are coupled to the pixel circuits. The plurality of signal lines can include scan signal lines Scan, first gate lines S1, second gate lines S2, third gate lines S3, fourth gate lines S4, first enable signal lines EM1, second enable signal lines EM2, first initial signal lines Vinit1, second initial signal lines Vinit2, first reference signal lines Ref1, second reference signal lines Ref2, data signal lines Data, first power supply lines VDD and second power supply lines VSS.

The first node N1 is coupled to a second electrode of the first transistor, a second electrode of the second transistor T2, a control electrode of the third transistor T3, and a second electrode plate of the first capacitor C1. The second node N2 is coupled to a first electrode of the third transistor T3, a second electrode of the eighth transistor T8, and a second electrode of the fifth transistor T5. The third node N3 is coupled to a first electrode of the second transistor T2, a second electrode of the third transistor T3, and a first electrode of the sixth transistor T6. The fourth node N4 is coupled to a second electrode of the sixth transistor T6 and a second electrode of the seventh transistor T7. The fifth node N5 is coupled to a second electrode of the fourth transistor T4, a second electrode of the ninth transistor T9, a first electrode plate of the first capacitor C1, and a second electrode plate of the second capacitor C2.

A control electrode of the first transistor T1 is coupled to the first gate line S1, a first electrode of the first transistor T1 is coupled to the first initial signal line Vinit1, and the second electrode of the first transistor T1 is coupled to the first node N1. The first transistor T1 transmits a first initial voltage to the control electrode of the third transistor T3 and the first capacitor C1, so that charges accumulated in the first capacitor C1 are released, thereby achieving initialization. The first transistor T1 may be referred to as a first initialization transistor.

A control electrode of the second transistor T2 is coupled to a second gate line S2, the second electrode of the second transistor T2 is coupled to the first node N1, and the first electrode of the second transistor T2 is coupled to the third node N3. When a turn-on signal is applied to the second gate line S2, the second transistor T2 allows the control electrode of the third transistor T3 to be coupled to the second electrode of the third transistor T3. The second transistor T2 may be referred to as a compensation transistor.

The control electrode of the third transistor T3 is coupled to the first node N1, the first electrode of the third transistor T3 is coupled to the second node N2, and the second electrode of the third transistor T3 is coupled to the third node N3. The third transistor T3 determines a magnitude of a driving current according to a potential difference between the control electrode and the first electrode of the third transistor T3. The third transistor T3 may be referred to as a driving transistor.

A control electrode of the fourth transistor T4 is coupled to the third gate line S3, a first electrode of the fourth transistor T4 is coupled to the data signal line Data, and the second electrode of the fourth transistor T4 is coupled to the fifth node N5. When a turn-on signal is applied to the third gate line S3, the fourth transistor T4 allows a data voltage of the data signal line Data to be input to the first capacitor C1 and the second capacitor C2. The fourth transistor T4 may be referred to as a data writing transistor.

A control electrode of the fifth transistor T5 is coupled to the first enable signal line EM1, a first electrode of the fifth transistor T5 is coupled to the first power supply line VDD, and the second electrode of the fifth transistor T5 is coupled to the second node N2. A control electrode of the sixth transistor T6 is coupled to the second enable signal line EM2, the first electrode of the sixth transistor T6 is coupled to the third node N3, and the second electrode of the sixth transistor T6 is coupled to the fourth node N4. When turn-on signals are applied to the first enable signal line EM1 and the second enable signal line EM2, the fifth transistor T5 and the sixth transistor T6 form a driving current path between the first power supply line VDD and the second power supply line VSS to enable the light-emitting device 20 to emit light. The fifth transistor T5 may be referred to as a first light-emitting writing transistor. The sixth transistor T6 may be referred to as a second light-emitting writing transistor.

A control electrode of the seventh transistor T7 is coupled to the scan signal line Scan, a first electrode of the seventh transistor T7 is coupled to the second initial signal line Vinit2, and the second electrode of the seventh transistor T7 is coupled to the fourth node N4. When a turn-on signal is applied to the scan signal line Scan, the seventh transistor T7 transmits a second initial voltage to a first electrode of the light-emitting device 20, so that charges accumulated in the first electrode of the light-emitting device 20 are released, thereby achieving initialization. The seventh transistor T7 may be referred to as a second initialization transistor.

A control electrode of the eighth transistor T8 is coupled to the scan signal line Scan, a first electrode of the eighth transistor T8 is coupled to the second reference signal line Ref2, and the second electrode of the eighth transistor T8 is coupled to the second node N2. When the turn-on signal is applied to the scan signal line Scan, the eighth transistor T8 transmits a second reference signal to the second node N2. The eighth transistor T8 may be referred to as a second reference transistor.

A control electrode of the ninth transistor T9 is coupled to the fourth gate line S4, a first electrode of the ninth transistor T9 is coupled to the first reference signal line Ref1, and the second electrode of the ninth transistor T9 is coupled to the fifth node N5. When a turn-on signal is applied to the fourth gate line S4, the ninth transistor T9 transmits a first reference signal to the fifth node N5. The ninth transistor T9 may be referred to as a first reference transistor.

The first electrode plate (upper electrode plate) of the first capacitor C1 is coupled to the fifth node N5, and the second electrode plate (lower electrode plate) of the first capacitor C1 is coupled to the first node N1.

The first electrode plate (upper electrode plate) of the second capacitor C2 is coupled to the first power supply line VDD, and the second electrode plate (lower electrode plate) of the second capacitor C2 is coupled to the fifth node N5.

The first electrode of the light-emitting device 20 is connected to the fourth node N4, and a second electrode of the light-emitting device 20 is connected to the second power supply line VSS. A signal of the second power supply line VSS is a continuous low level signal, and a signal of the first power supply line VDD is a continuous high level signal.

In some examples, the first transistor T1 to the ninth transistor T9 are P-type transistors, or the first transistor T1 to the ninth transistor T9 are N-type transistors. By using the same type of transistors in the pixel driving circuit, the process may be simplified, thereby reducing the process difficulty of the display substrate, and improving the product yield. In some other examples, the first transistor T1 to the ninth transistor T9 include P-type transistors and N-type transistors.

For example, the first transistor T1 to the ninth transistor T9 are low-temperature polysilicon thin film transistors or oxide thin film transistors, or includes low-temperature polysilicon thin film transistors and oxide thin film transistors. An active layer of the low-temperature polysilicon thin film transistor uses low-temperature polysilicon (LTPS), and an active layer of the oxide thin film transistor uses oxide semiconductor (Oxide). Low-temperature polysilicon thin film transistors have the advantages of high mobility and fast charging, while oxide thin film transistors have the advantages of low leakage current. By integrating low-temperature polysilicon thin film transistors and oxide thin film transistors in the display substrate (i.e., using the display substrate with LTPS+Oxide (LTPO), the advantages of both may be utilized to achieve low-frequency driving, the power consumption may be reduced, and display quality may be improved.

In some examples, a working process of the pixel circuit shown in FIG. 4 includes a first phase to a fifth phase.

For the first phase, the first phase may include multiple sub-phases that are repeatedly executed, and each sub-phase may include a first sub-phase and a second sub-phase that are executed in sequence.

In the first sub-phase, signals of the first gate line S1 and the first enable signal line EM1 are turn-on signals, and signals of other signal lines are turn-off signals. A signal of the first gate line S1 is a turn-on signal, the turn-on signal enables the first transistor T1 to be turned on, and a first initial signal of the first initial signal line Vinit1 can be provided to the first node N1 to initialize the first node N1. In a case where the third transistor T3 is a P-type transistor, the third transistor T3 is turned on. A turn-on signal of the first enable signal line EM1 enables the fifth transistor T5 to be turned on, and a first power supply signal of the first power supply line VDD can be provided to the second node N2.

In the second sub-phase, signals of the second gate line S2, the fourth gate line S4 and the first enable signal line EM1 are turn-on signals, and signals of other signal lines are turn-off signals. A signal of the second gate line S2 and a signal of the fourth gate line S4 may be the same. The signal of the second gate line S2 is a turn-on signal, the turn-on signal enables the second transistor T2 to be turned on to connect the first node N1 and the third node N3, and a threshold voltage of the third transistor T3 is written into the first node N1. The signal of the fourth gate line S4 is a turn-on signal, the turn-on signal enables the ninth transistor T9 to be turned on, and a first reference signal of the first reference signal line Ref1 is provided to the fifth node N5 to initialize the fifth node N5. The turn-on signal of the first enable signal line EM1 enables the fifth transistor T5 to be turned on, and the first power supply signal of the first power supply line VDD can be provided to the second node N2.

In the second phase, a signal of the third gate line S3 is a turn-on signal, and signals of other signal lines are turn-off signals. The signal of the third gate line S3 is the turn-on signal, the turn-on signal enables the fourth transistor T4 to be turned on, and a data voltage provided by the data signal line Data is written into the fifth node N5.

In the third phase, a signal of the scan signal line Scan is a turn-on signal, and signals of other signal lines are turn-off signals. The signal of the scan signal line Scan is the turn-on signal, the turn-on signal enables the seventh transistor T7 to be turned on, and a second initial signal of the second initial signal line Vinit2 can be written into the fourth node N4 to initialize the fourth node N4, which prevents a residual signal of a previous frame from affecting display of a current frame. The signal of the scan signal line Scan is the turn-on signal, the turn-on signal enables the eighth transistor T8 to be turned on, and a second reference signal of the second reference signal line Ref2 can be written into the second node N2.

In the fourth phase, a signal of the second enable signal line EM2 is a turn-on signal, and signals of other signal lines are turn-off signals. The signal of the second enable signal line EM2 is the turn-on signal, the turn-on signal enables the sixth transistor T6 to be turned on to connect the third node N3 and the fourth node N4, so that potentials of the third node N3 and the fourth node N4 are the same.

In the fifth phase, signals of the first enable signal line EM1 and the second enable signal line EM2 are turn-on signals, and signals of other signal lines are turn-off signals. The signals of the first enable signal line EM1 and the second enable signal line EM2 are the turn-on signals, and the turn-on signals enable the fifth transistor T5 and the sixth transistor T6 to be turned on. The first power supply signal of the first power supply line VDD may pass through the turned-on fifth transistor T5, third transistor T3 and sixth transistor T6 to provide a driving signal for the light-emitting device 20, thereby driving the light-emitting device 20 to emit light.

For example, when the driving transistor (i.e., the third transistor T3) is in a single state for a long time, electrons can be trapped in a trap, causing hysteresis. Therefore, in the first phase, by performing the initialization and threshold voltage writing process on the first node N1 multiple times (for example, three times), not only may the hysteresis of the driving transistor be reduced, but also the potential stability of the first node N1 may be ensured. In the third phase, the second reference signal is written into the second node N2, which may help reduce the hysteresis of the driving transistor by changing the potential of the second node N2. In the fourth stage, the third node N3 and the fourth node N4 are connected, so that the potential of the fourth node N4 may be increased, which is beneficial to shortening the time required to reach the lighting voltage of the light-emitting device 20 subsequently. The pixel circuit provided in the present disclosure may effectively alleviate the hysteresis of the driving transistor, which is beneficial to improving the display effect of the display substrate 100.

In some other examples, a working process of the pixel circuit shown in FIG. 4 includes a sixth period to a tenth period.

In the sixth phase, a signal of the first gate line S1 is a turn-on signal, and signals of other signal lines are turn-off signals. The signal of the first gate line S1 is the turn-on signal, the turn-on signal enables the first transistor T1 to be turned on, and a first initial signal of the first initial signal line Vinit1 can be provided to the first node N1 to initialize the first node N1. A voltage of the first node N1 is a voltage of the first initial signal.

In the seventh phase, a signal of the scan signal line Scan is a turn-on signal, and signals of other signal lines are turn-off signals. The signal of the scan signal line Scan is the turn-on signal, the turn-on signal enables the seventh transistor T7 to be turned on, and a second initial signal of the second initial signal line Vinit2 can be written into the fourth node N4 to initialize the fourth node N4, which prevents a residual signal of a previous frame from affecting display of a current frame. The signal of the scan signal line Scan is the turn-on signal, the turn-on signal enables the eighth transistor T8 to be turned on, and a second reference signal of the second reference signal line Ref2 can be written into the second node N2. In a case where the third transistor T3 is a P-type transistor, the third transistor T3 is turned on. A turn-on signal of the second gate line S2 enables the second transistor T2 to be turned on to connect the first node N1 and the third node N3. The second reference signal may be written into the first node N1 through the eighth transistor T8, the third transistor T3, and the second transistor T2 in sequence, and the voltage of the first node N1 is a voltage of the second reference signal.

In the eighth phase, signals of the second gate line S2, the fourth gate line S4 and the first enable signal line EM1 are turn-on signals, and signals of other signal lines are turn-off signals. A signal of the second gate line S2 and a signal of the fourth gate line S4 may be the same. The signal of the second gate line S2 is a turn-on signal, the turn-on signal enables the second transistor T2 to be turned on to connect the first node N1 and the third node N3. The signal of the fourth gate line S4 is a turn-on signal, the turn-on signal enables the ninth transistor T9 to be turned on, and a first reference signal of the first reference signal line Ref1 is provided to the fifth node N5 to initialize the fifth node N5. A turn-on signal of the first enable signal line EM1 enables the fifth transistor T5 to be turned on, and a first power supply signal of the first power supply line VDD can be provided to the second node N2. The first power supply signal may pass through the fifth transistor T5, third transistor T3 and second transistor T2 in sequence to be provided to the first node N1. The voltage of the first node N1 is a sum of the voltage of the first power supply signal and the threshold voltage of the third transistor T3.

In the ninth phase, a signal of the third gate line S3 is a turn-on signal, and signals of other signal lines are turn-off signals. The signal of the third gate line S3 is the turn-on signal, the turn-on signal enables the fourth transistor T4 to be turned on, and a data voltage provided by the data signal line Data is written into the fifth node N5. The data voltage provided by the data signal line Data may be provided to the first node N1 through the fifth node N5 and the first capacitor C1. A potential difference between the first electrode plate and the second electrode plate of the first capacitor C1 will not change instantaneously. A change of the voltage on the first electrode plate of the first capacitor C1 is a voltage difference between the data voltage and the voltage of the first reference signal; and correspondingly, the voltage on the second electrode plate of the first capacitor C1 will also undergo the same change. Thus, the voltage of the first node N1 is a difference between a sum of the voltage of the first power supply signal, the threshold voltage of the third transistor T3 and the data voltage, and the voltage of the first reference signal.

In the tenth phase, signals of the first enable signal line EM1 and the second enable signal line EM2 are turn-on signals, and signals of other signal lines are turn-off signals. The signals of the first enable signal line EM1 and the second enable signal line EM2 are the turn-on signals, and the turn-on signals enable the fifth transistor T5 and the sixth transistor T6 to be turned on. The first power supply signal of the first power supply line VDD may pass through the turned-on fifth transistor T5, third transistor T3 and sixth transistor T6 to provide a driving signal for the light-emitting device 20, thereby driving the light-emitting device 20 to emit light.

As shown in FIG. 3, the driving circuit layer 10 can further include an insulating layer INL located on the first pixel circuit S1, the second pixel circuit S2 and the third pixel circuit S3. The insulating layer INL may have a flat surface. The insulating layer INL may be formed from an organic layer. For example, the insulating layer INL is made of acrylic resin, epoxy resin, imide resin or ester resin. The insulating layer INL can have via holes exposing electrodes of the first pixel circuit S1, the second pixel circuit S2 and the third pixel circuit S3, so as to achieve electrical connections.

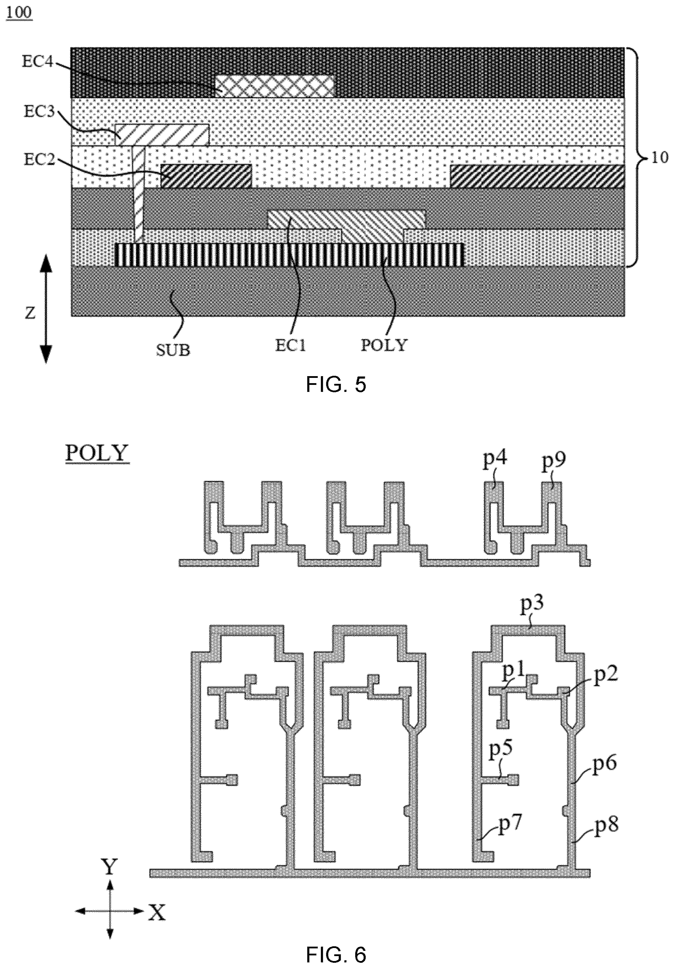

FIG. 5 is a sectional view of a base substrate and a driving circuit layer in a display substrate, in accordance with some embodiments.

As shown in FIG. 5, the driving circuit layer 10 provided in the embodiments of the present disclosure can include a semiconductor layer POLY, a first conductive layer EC1, a second conductive layer EC2, a third conductive layer EC3 and a fourth conductive layer EC4, which are located between the base substrate SUB and the light-emitting devices 20 and are arranged in sequence in a direction away from the base substrate SUB.

FIG. 6 is a structural diagram of a semiconductor layer in a display substrate, in accordance with some embodiments.

As shown in FIG. 6, the semiconductor layer POLY can include active layers of the plurality of transistors in the pixel circuit. Considering an example where the pixel circuit includes the first transistor T1 to the ninth transistor T9, the semiconductor layer POLY includes an active layer p1 of the first transistor T1 to an active layer p9 of the ninth transistor T9.

In some examples, the active layer p1 of the first transistor T1 to an active layer p3 of the third transistor T3, and an active layer p5 of the fifth transistor T5 to an active layer p8 of the eighth transistor T8 are connected to each other to form a one-piece structure.

In some examples, an active layer p4 of the fourth transistor T4 and the active layer p9 of the ninth transistor T9 are connected to each other to form a one-piece structure.

In some examples, as shown in FIG. 6, portions of the semiconductor layer POLY in multiple pixel circuits located in a same column (parallel to the second direction Y) are separated from each other. In some other examples, portions of the semiconductor layer POLY in multiple pixel circuits located in a same column (parallel to the second direction Y) are connected to each other to form a one-piece structure.

In some examples, as shown in FIG. 6, portions of the semiconductor layer POLY in multiple pixel circuits located in a same row (parallel to the first direction X) are connected to each other to form a one-piece structure. In some other examples, portions of the semiconductor layer POLY in multiple pixel circuits located in a same row (parallel to the first direction X) are separated from each other.

For example, a material of the semiconductor layer POLY includes low temperature polysilicon (LTPS), or low temperature polycrystalline oxide (LTPO), or any other suitable material, which is not limited here.

In some embodiments, a first insulating layer can be included and located between the semiconductor layer POLY and the first conductive layer EC1. A material of the first insulating layer may be any one or a combination of an oxide, a nitride or an oxynitride, which is not limited here.

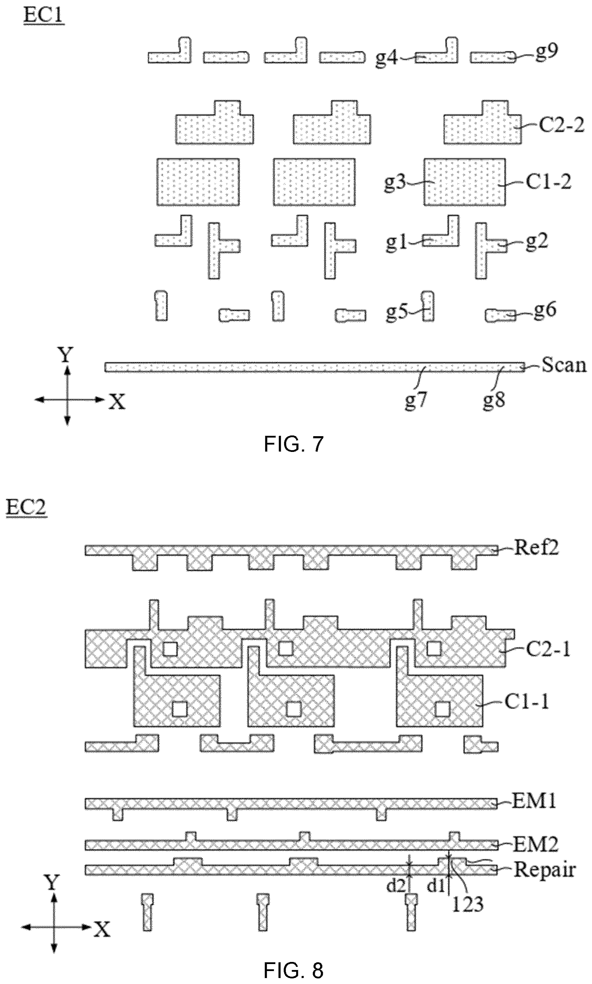

FIG. 7 is a structural diagram of a first conductive layer in a display substrate, in accordance with some embodiments.

In some embodiments, as shown in FIG. 7, the first conductive layer EC1 can include the scan signal lines Scan, the second electrode plates C1-2 of the first capacitors C1, and the second electrode plates C2-2 of the second capacitors C2. An extension direction of the scan signal line Scan is parallel to the first direction X. In the second direction Y, the scan signal line Scan, the second electrode plate C1-2 of the first capacitor C1 and the second electrode plate C2-2 of the second capacitor C2 are arranged at intervals from each other, and the second electrode plate C1-2 of the first capacitor C1 can be located between the second electrode plate C2-2 of the second capacitor C2 and the scan signal line Scan. The first direction X and the second direction Y intersect with each other.

In some examples, as shown in FIG. 7, the control electrode g3 of the third transistor T3 and the second electrode plate C1-2 of the first capacitor C1 are connected to each other to form a one-piece structure. It can be understood that the second electrode plate C1-2 of the first capacitor C1 can serve as the control electrode g3 of the third transistor T3.

In some examples, as shown in FIG. 7, the control electrode g7 of the seventh transistor T7, the control electrode g8 of the eighth transistor T8, and the scan signal line Scan are connected to each other to form a one-piece structure. It can be understood that, a portion of the scan signal line Scan serves as the control electrode g7 of the seventh transistor T7, and another portion of the scan signal line Scan serves as the control electrode g8 of the eighth transistor T8.

For example, materials of the first conductive layer EC1, the second conductive layer EC2, the third conductive layer EC3 and the fourth conductive layer EC4 include a metal material, an alloy material, or any other conductive material.

For example, materials of the first conductive layer EC1 and the second conductive layer EC2 include copper (Cu) or molybdenum (Mo).

For example, materials of the third conductive layer EC3 and the fourth conductive layer EC4 include titanium (Ti), aluminum (Al), or a Ti/Al/Ti laminated composite material.

In some embodiments, a second insulating layer can further be provided between the first conductive layer EC1 and the second conductive layer EC2. A material of the second insulating layer may be similar to that of the first insulating layer, which will not be repeated here.

FIG. 8 is a structural diagram of a second conductive layer in a display substrate, in accordance with some embodiments.

As shown in FIG. 8, the second conductive layer EC2 can include repair signal lines Repair, the first enable signal lines EM1, the second enable signal lines EM2, the first electrode plates C1-1 of the first capacitors C1, the first electrode plates C2-1 of the second capacitors C2, and the second reference signal lines Ref2. Extension directions of the repair signal line Repair, the first enable signal line EM1, the second enable signal line EM2 and the second reference signal line Ref2 are substantially parallel to the first direction X, and the repair signal line Repair, the first enable signal line EM1, the second enable signal line EM2 and the second reference signal line Ref2 are arranged at intervals in the second direction Y.

In the second direction Y, the second enable signal line EM2 can be located between the first enable signal line EM1 and the repair signal line Repair, the first electrode plate C1-1 of the first capacitor C1 and the first electrode plate C2-1 of the second capacitor C2 can be located between the first enable signal line EM1 and the second reference signal line Ref2, and the first electrode plate C2-1 of the second capacitor C2 can be located between the first electrode plate C1-1 of the first capacitor C1 and the second reference signal line Ref2.

In some examples, as shown in FIG. 8, the repair signal line Repair includes repair blocks 123. In a direction (i.e., the second direction Y) perpendicular to an extension of the repair signal line Repair, a dimension d1 of the repair block 123 (a width of the repair block 123) is greater than a dimension d2 of the repair signal line Repair. The repair blocks 123 and the repair signal line Repair can be connected to each other to form a one-piece structure.

In this way, an area of the repair signal line Repair may be relatively large, so that the repair signal line Repair may provide a relatively stable voltage for a light-emitting device 20 to be repaired, which may improve a repair effect on the light-emitting device 20 to be repaired, and in turn, improve the manufacturing yield of the display substrate 100.

For example, the repair signal line Repair is in a shape of a straight line whose main body portion extends in the first direction X.

In some examples, the first electrode plates C2-1 of the second capacitors C2 in multiple pixel circuits in a same row (parallel to the first direction X) are connected to each other to form a one-piece structure.

In some embodiments, a third insulating layer can further be provided between the second conductive layer EC2 and the third conductive layer EC3. A material of the third insulating layer may be similar to that of the first insulating layer, which will not be repeated here.

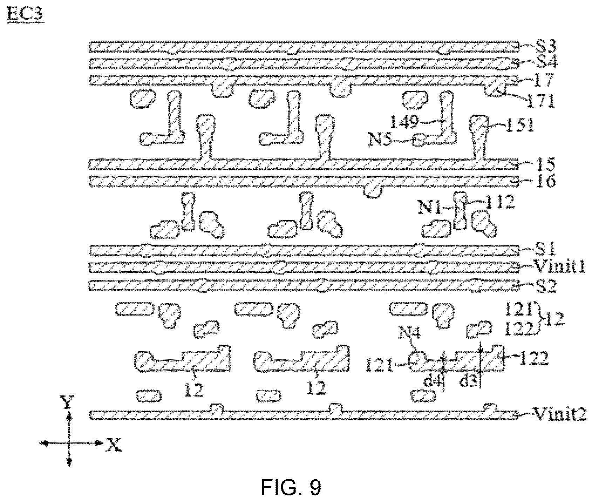

FIG. 9 is a structural diagram of a third conductive layer in a display substrate, in accordance with some embodiments.

In some embodiments, as shown in FIG. 9, the third conductive layer EC3 can include transition components 12, the first initial signal lines Vinit1, the second initial signal lines Vinit2, the first gate lines S1, the second gate lines S2, the third gate lines S3, the fourth gate lines S4, first power supply connection lines 15, second power supply connection lines 16, and first reference signal connection lines 17. Extension directions of the first initial signal line Vinit1, the second initial signal line Vinit2, the first gate line S1, the second gate line S2, the third gate line S3, the fourth gate line S4 and the first reference signal connection line 17 are substantially parallel to the first direction X, and the second initial signal line Vinit2, the first gate line S1, the second gate line S2, the third gate line S3, the fourth gate line S4 and the first reference signal connection line 17 are arranged at intervals in the second direction Y.

The second gate line S2 can be located between the first initial signal line Vinit1 and the second initial signal line Vinit2. In the second direction Y and on a side of the first initial signal line Vinit1 away from the second gate line S2, the first gate line S1, the second power supply connection line 16, the first power supply connection line 15, the first reference signal connection line 17, the fourth gate line S4 and the third gate line S3 are sequentially arranged at intervals. Multiple transition components 12 can be located between the second gate line S2 and the second initial signal line Vinit2. In the first direction X, the multiple transition components 12 are arranged at intervals from each other.

In some examples, as shown in FIG. 9, the third conductive layer EC3 further includes first connection blocks 149. The first connection block 149 can include the fifth node N5. The first connection block 149 can be located between the first reference signal connection line 17 and the first power supply connection line 15. A first end of the first connection block 149 is coupled to the second electrode of the fourth transistor T4 and the second electrode of the ninth transistor T9, a second end of the first connection block 149 is coupled to the second electrode plate C2-2 of the second capacitor C2, and a third end of the first connection block 149 is coupled to the first electrode plate C1-1 of the first capacitor C1.

For example, a shape of the first connection block 149 is L-shaped, or the first connection block 149 has any other shape.

In some examples, as shown in FIG. 9, the third conductive layer EC3 further includes second connection blocks 151. A first end of the second connection block 151 is coupled to the first electrode plate C2-1 of the second capacitor C2, and a second end of the second connection block 151 is coupled to the first power supply connection line 15.

For example, the first power supply connection line 15 and the second connection block 151 are connected to each other to form a one-piece structure.

In some examples, as shown in FIG. 9, the third conductive layer EC3 further includes third connection blocks 112. The third connection block 112 can be located between the second power supply connection line 16 and the first gate line S1. The third connection block 112 can include the first node N1. A first end of the third connection block 112 is coupled to the second electrode plate C1-2 of the first capacitor C1, and a second end of the third connection block 112 is coupled to the second electrode of the first transistor T1 and the first electrode of the second transistor T2.

In some examples, as shown in FIGS. 4 and 9, the transition component 12 is coupled to the pixel circuit and the light-emitting device 20. For example, the transition component 12 includes the fourth node N4; one end of the transition component 12 is coupled to the second electrode of the sixth transistor T6 and the second electrode of the seventh transistor T7, and the other end of the transition component 12 is coupled to the anode of the light-emitting device 20. In this way, the pixel circuit may be coupled to the light-emitting device 20 through the transition component 12, thereby controlling the light-emitting brightness of the light-emitting device 20.

In some examples, as shown in FIG. 9, the transition component 12 includes a first transition portion 121 and a second transition portion 122. The first transition portion 121 is coupled to the anode of the light-emitting device 20, and the second transition portion 122 is coupled to the repair signal line Repair.

In a direction perpendicular to an extension direction of the repair signal line Repair, a dimension d3 of the second transition portion 122 (a width of the second transition portion 122) is greater than a dimension d4 of the first transition portion 121 (a width of the first transition portion 121).

In this way, the second transition portion 122 and the repair signal line Repair may form a repair unit. The dimension d3 of the second transition portion 122 is greater than the dimension d4 of the first transition portion 121, so that an area of the repair unit may be large. Thus, the repair unit may provide a relatively stable voltage for the light-emitting device 20 to be repaired, and the repair effect of the repair unit on the light-emitting device 20 to be repaired may be improved, thereby improving the manufacturing yield of the display substrate 100.

In some examples, as shown in FIG. 9, patterned shapes of the transition components 12 coupled to the plurality of light-emitting devices 20 are substantially the same.

The patterned structures of the transition components 12 are the same, and thus the repair units may provide a stable voltage for different color light-emitting devices 20 to be repaired. As a result, the repair units have the same repair effect on the different color light-emitting devices 20 to be repaired, thereby improving the uniformity of the luminous efficiency of the different color light-emitting devices 20 in the display substrate 100.

For example, the patterned shape of the transition component 12 coupled to the first light-emitting device LD1 is substantially the same as the patterned shape of the transition component 12 coupled to the second light-emitting device LD2.

In this way, the repair units may provide a stable voltage for the first light-emitting device LD1 to be repaired and the second light-emitting device LD2 to be repaired, and thus the repair units may have the same repair effect on the first light-emitting device LD1 to be repaired and the second light-emitting device LD2 to be repaired, thereby improving the uniformity of the luminous efficiency of the first light-emitting device LD1 to be repaired and the second light-emitting device LD2 to be repaired in the display substrate 100.

For example, the patterned shape of the transition component 12 coupled to the first light-emitting device LD1 is substantially the same as the patterned shape of the transition component 12 coupled to the third light-emitting device LD3.

In this way, the repair units may provide a stable voltage for the first light-emitting device LD1 to be repaired and the third light-emitting device LD3 to be repaired, and thus the repair units may have the same repair effect on the first light-emitting device LD1 to be repaired and the third light-emitting device LD3 to be repaired, thereby improving the uniformity of the luminous efficiency of the first light-emitting device LD1 to be repaired and the third light-emitting device LD3 to be repaired in the display substrate 100.

For example, the patterned shape of the transition component 12 coupled to the first light-emitting device LD1, the patterned shape of the transition component 12 coupled to the second light-emitting device LD2, and the patterned shape of the transition component 12 coupled to the third light-emitting device LD3 are substantially the same.

In this way, the repair units may provide a stable voltage for the first light-emitting device LD1 to be repaired, the second light-emitting device LD2 to be repaired and the third light-emitting device LD3 to be repaired, and thus the repair units may have the same repair effect on the first light-emitting device LD1 to be repaired, the second light-emitting device LD2 to be repaired and the third light-emitting device LD3 to be repaired, thereby improving the uniformity of the luminous efficiency of the first light-emitting device LD1 to be repaired, the second light-emitting device LD2 to be repaired and the third light-emitting device LD3 to be repaired in the display substrate 100.

For example, a shape of the transition component 12 includes a shape of the Chinese character " 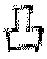 ", a polygon, or any other shape.

For example, as shown in FIG. 9, reference signal connection blocks 171 are provided on the first reference signal connection line 17. The first reference signal connection line 17 can be connected to the first reference signal line Ref1 through a reference signal connection block 171.

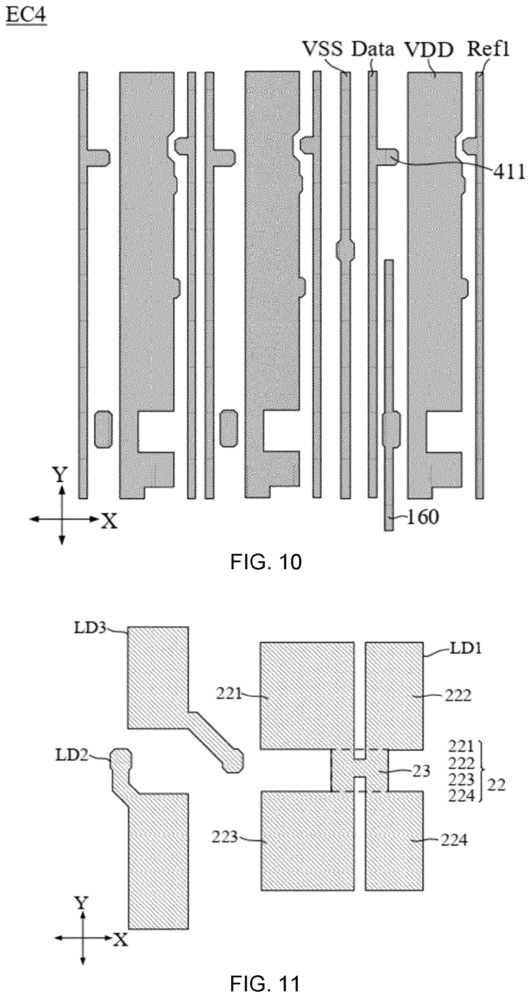

FIG. 10 is a structural diagram of a fourth conductive layer in a display substrate, in accordance with some embodiments.

In some embodiments, a fourth insulating layer can further be provided between the third conductive layer EC3 and the fourth conductive layer EC4. A material of the fourth insulating layer may be similar to that of the first insulating layer, which will not be repeated here.

In some embodiments, the fourth conductive layer EC4 can be located between the third conductive layer EC3 and the anodes of the light-emitting devices 20. As shown in FIG. 10, the fourth conductive layer EC4 can include the first power supply lines VDD, the second power supply lines VSS, the data signal lines Data, and the first reference signal lines Ref1. Extension directions of the first power supply lines VDD, the second power supply lines VSS, the data signal lines Data, and the first reference signal lines Ref1 are substantially parallel to the second direction Y, and are arranged at intervals in the first direction X.

The first power supply line VDD and the data signal line Data can be located between the first reference signal line Ref1 and the second power supply line VSS. The first power supply line VDD can be located between the first reference signal line Ref1 and the data signal line Data.

It can be understood that the first power supply line VDD, the second power supply line VSS, the data signal line Data and the first reference signal line Ref1 can be arranged in the same layer.

In some embodiments, the first power supply line VDD, the second power supply line VSS, the data signal line Data and the first reference signal line Ref1 are arranged in different layers, and at least two conductive layers are required to arrange the first power supply line VDD, the second power supply line VSS, the data signal line Data and the first reference signal line Ref1. In the embodiments, the first power supply line VDD, the second power supply line VSS, the data signal line Data and the first reference signal line Ref1 are arranged in the same layer, so that some conductive layers in the display substrate 100 may be omitted, thereby reducing the manufacturing processes of the display substrate 100 and reducing the manufacturing cost of the display substrate 100. In addition, a dimension of the display substrate 100 in the third direction Z (i.e., a thickness of the display substrate 100) may be reduced, which is convenient for achieving the light weight and small thickness of the display substrate 100.

For example, the second power supply line VSS is in a shape of a straight line whose main body portion extends in the second direction Y.

In some examples, as shown in FIG. 10, data signal connection blocks 411 are provided on the data signal line Data. A first end of the data signal connection block 411 is connected to the data signal line Data, and a second end of the data signal connection block 411 can be coupled to the first electrode of the fourth transistor T4, so that the data signal line Data can write the data signal into the first electrode of the fourth transistor T4.

For example, the data signal line Data is in a shape of a straight line whose main body portion extends in the second direction Y.

In some examples, as shown in FIG. 10, the fourth conductive layer EC4 further includes filling blocks 160. The filling block 160 is located between the data signal line Data and the first power supply line VDD.

For example, the filling block 160 is in a shape of a straight line whose main body portion extends in the second direction Y.

FIG. 11 is a structural diagram of anodes of light-emitting devices in a display substrate, in accordance with some embodiments.

As shown in FIG. 3, the display substrate 100 can include a pixel defining layer PDL located on the base substrate SUB. The pixel defining layer PDL can be formed on the insulating layer INL, and the pixel defining layer PDL can include a plurality of light-emitting openings. The plurality of light-emitting devices 20 cover the plurality of light-emitting openings, respectively.

As shown in FIGS. 3 and 11, in a pixel unit region PU, multiple light-emitting devices 20 can include a first light-emitting device LD1, a second light-emitting device LD2 and a third light-emitting device LD3 that respectively display different colors. The first light-emitting device LD1 can be located in the first sub-pixel region P1, the second light-emitting device LD2 can be located in the second sub-pixel region P2, and the third light-emitting device LD3 can be located in the third sub-pixel region P3. For example, the first light-emitting device LD1 is a blue light-emitting device, the second light-emitting device LD2 is a green light-emitting device, and the third light-emitting device LD3 is a red light-emitting device.

For example, in the multiple light-emitting devices 20, a size of a light-emitting region EAof the first light-emitting device LD1 is greater than that of a light-emitting region EA of the second light-emitting device LD2, and the size of the light-emitting region EA of the first light-emitting device LD1 is greater than that of a light-emitting region EA of the third light-emitting device LD3. It can be understood that, an area of the anode of the first light-emitting device LD1 can be greater than that of the anode of the second light-emitting device LD2, and the area of the anode of the first light-emitting device LD1 can be greater than that of the anode of the third light-emitting device LD3.

For example, the light-emitting device 20 is an OLED, and the OLED includes a first electrode (e.g., an anode), an organic light-emitting layer, and a second electrode (e.g., a cathode) that are stacked. Alternatively, the light-emitting device 20 is a QLED, and the QLED includes a first electrode (e.g., an anode), a quantum dot light-emitting layer, and a second electrode (e.g., a cathode) that are stacked.

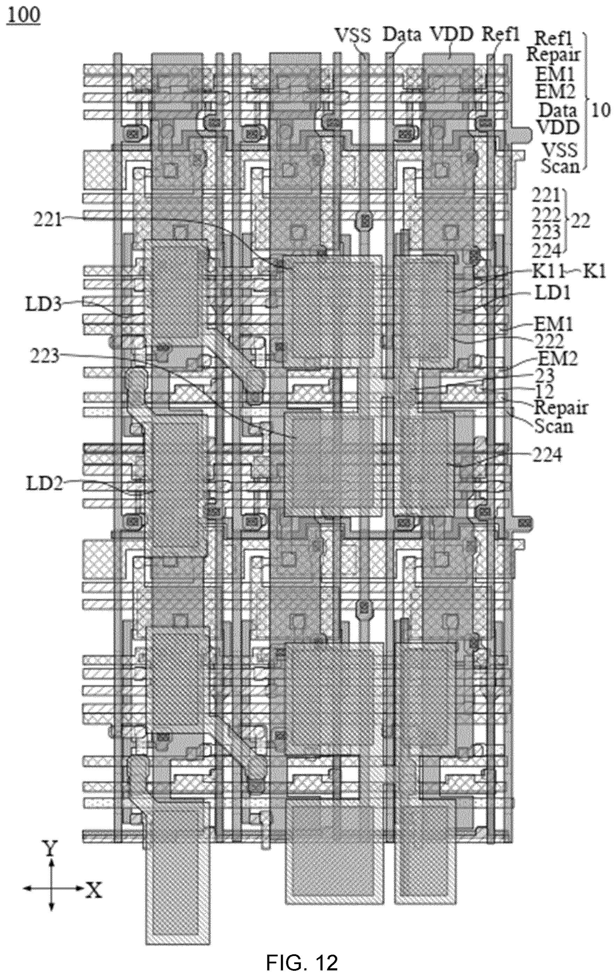

FIG. 12 is a structural diagram of pixel circuits and anodes in a display substrate, in accordance with some embodiments.

In some embodiments, as shown in FIGS. 11 and 12, the anode of the first light-emitting device LD1 can include a plurality of sub-anodes 22 and a connection portion 23. The plurality of sub-anodes 22 are connected to the connection portions 23. For example, the plurality of sub-anodes 22 and the connection portion 23 in the first light-emitting device LD1 are connected to each other to form a one-piece structure.

There is a gap between adjacent sub-anodes 22. It can be understood that, in the first direction X, there is a gap between adjacent sub-anodes 22 in the first light-emitting device LD1; and in the second direction Y, there is also a gap between adjacent sub-anodes 22 in the first light-emitting device LD1.

For example, a shape of the sub-anode 22 is rectangular, trapezoidal, or polygonal. The sub-anode 22 may also have any other shape that is convenient for exposing key signal line(s).

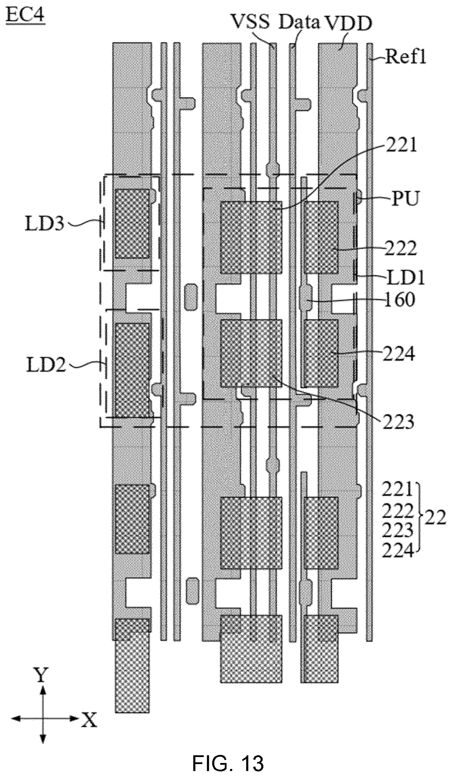

FIG. 13 is a structural diagram of a fourth conductive layer and sub-anodes in a display substrate, in accordance with some embodiments.

As shown in FIG. 13, the data signal lines Data are located in the non-light-emitting region FA. Orthographic projections of the data signal lines Data on the base substrate SUB are non-overlapping with orthographic projections of the sub-anodes 22 on the base substrate SUB.

In this way, the data signal line Data may avoid the sub-anode 22, and an area of overlapping between the data signal line Data and the anode of the light-emitting device 20 may be reduced as much as possible, thereby reducing a parasitic capacitance between the data signal line Data and the anode of the light-emitting device 20, improving a stability of an operating voltage of the light-emitting device 20, and in turn, improving the display effect of the display substrate 100.

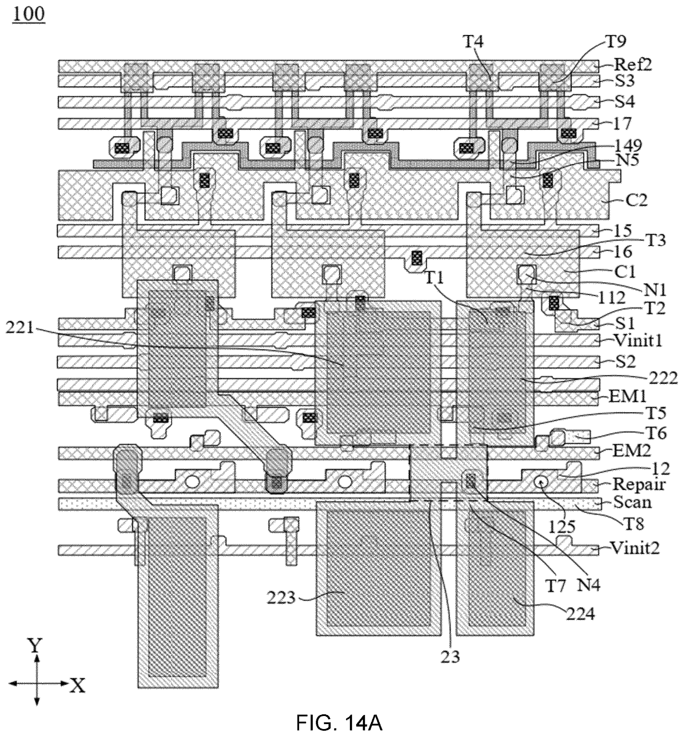

FIGS. 14A to 14C are structural diagrams showing a pixel circuit and an anode in a display substrate, in accordance with some embodiments.

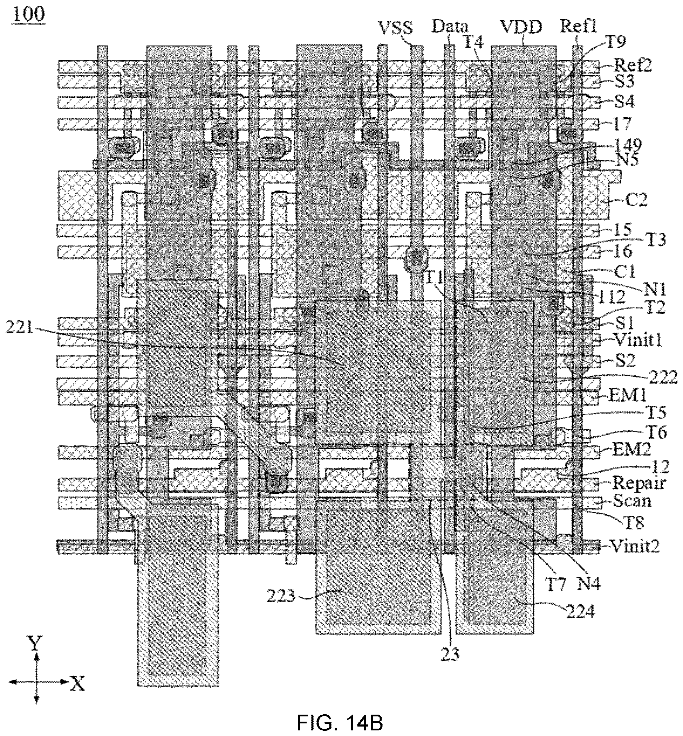

In some examples, as shown in FIGS. 13 and 14B, a part of the sub-anodes 22 in the first light-emitting device LD1 is located on a side of the data signal line Data coupled to the first light-emitting device LD1, and another part of the sub-anodes 22 in the first light-emitting device LD1 is located on another side of the data signal line Data coupled to the first light-emitting device LD1. It can be understood that the data signal line Data coupled to the first light-emitting device LD1 is located in the gap between adjacent sub-anodes 22 in the first light-emitting device LD1.

In this way, in a case where the area of the anode of the first light-emitting device LD1 in the display substrate 100 is relatively large, the data signal line Data may avoid the sub-anodes 22 of the first light-emitting device LD1, and the area of overlapping between the data signal line Data and the anode of the first light-emitting device LD1 may be reduced as much as possible, thereby reducing the parasitic capacitance between the data signal line Data and the anode of the first light-emitting device LD1, improving the stability of the operating voltage of the first light-emitting device LD1, and in turn, improving the display effect of the display substrate 100.

In some embodiments, an orthographic projection of one enable signal line coupled to the light-emitting device 20 on the base substrate SUB is non-overlapping with orthographic projections of the sub-anodes 22 on the base substrate SUB.

For example, as shown in FIGS. 8 and 14B, an orthographic projection of the second enable signal line EM2 on the base substrate SUB is non-overlapping with orthographic projections of the sub-anodes 22 on the base substrate SUB.

In this way, the one enable signal line coupled to the light-emitting device 20 may avoid a region where the sub-anodes 22 are located, and no parasitic capacitance is generated between the one enable signal line and the sub-anodes 22 of the light-emitting device 20, which may reduce the parasitic capacitance between the one enable signal line and the anode of the light-emitting device 20 in an overlapping region, and enable the one enable signal line to provide a stable enable signal for the light-emitting device 20. Thus, the light-emitting device 20 may emit light stably, thereby improving the display effect of the display substrate 100.

In some embodiments, the repair signal lines Repair are located in the non-light-emitting region FA.

In this way, the repair signal line Repair may be coupled to the light-emitting device 20 to be repaired, so that the repair signal line Repair may provide a stable voltage for the light-emitting device 20 to be repaired, thereby achieving the repair of the light-emitting device 20 to be repaired, and improving the manufacturing yield of the display substrate 100.

In some examples, as shown in FIG. 14B, a part of the sub-anodes 22 in the first light-emitting device LD1 is located on a side of the repair signal line Repair, and another part of the sub-anodes 22 in the first light-emitting device LD1 is located on another side of the repair signal line Repair. It can be understood that, in the second direction Y, the repair signal line Repair can be located in the non-light-emitting region FA between the part of the sub-anodes 22 and the another part of the sub-anodes 22, which are adjacent, in the first light-emitting device LD1.

The repair signal line Repair is arranged in the non-light-emitting region FA between the plurality of sub-anodes 22 in the first light-emitting device LD1, which may avoid overlapping between the plurality of sub-anodes 22 in the first light-emitting device LD1 and the repair signal line Repair, and reduce overlapping between the anode of the first light-emitting device LD1 and the repair signal line Repair as much as possible. Thus, when the repair signal line Repair is coupled to the light-emitting device 20 to be repaired, the repair signal line Repair may provide a stable voltage for the light-emitting device 20 to be repaired, thereby achieving the repair of the light-emitting device 20 to be repaired, and improving the manufacturing yield of the display substrate 100.

For example, as shown in FIG. 14B, the anode of the first light-emitting device LD1 includes four sub-anodes 22 and one connection portion 23. The connection portion 23 can be located among the four sub-anodes 22 in which every two sub-anodes 22 are adjacent. The four sub-anodes 22 can include a first sub-anode 221, a second sub-anode 222, a third sub-anode 223, and a fourth sub-anode 224. In the first direction X, the first sub-anode 221 and the second sub-anode 222 may be located in a same row, and the third sub-anode 223 and the fourth sub-anode 224 may be located in another row.

The data signal line Data coupled to the first light-emitting device LD1 is located in a gap between the adjacent first sub-anode 221 and second sub-anode 222 in the first light-emitting device LD1 and in a gap between the adjacent third sub-anode 223 and fourth sub-anode 224 in the first light-emitting device LD1.

In this way, in a case where the area of the anode of the first light-emitting device LD1 in the display substrate 100 is relatively large, the data signal line Data may be arranged in the gap between the four sub-anodes 22 in which every two sub-anodes 22 are adjacent. Thus, the area of overlapping between the data signal line Data and the anode of the first light-emitting device LD1 may be reduced to the area of overlapping between the data signal line Data and the connection portion 23, thereby significantly reducing the parasitic capacitance between the data signal line Data and the anode of the first light-emitting device LD1, improving the stability of the operating voltage of the first light-emitting device LD1, and in turn, improving the display effect of the display substrate 100.

As shown in FIGS. 8, 12 and 14B, the repair signal line Repair can be located between the adjacent first sub-anode 221 and third sub-anode 223 in the first light-emitting device LD1, and between the adjacent second sub-anode 222 and fourth sub-anode 224 in the first light-emitting device LD1. It can be understood that, the repair signal line Repair may be located between the first sub-anode 221, second sub-anode 222, third sub-anode 223, and fourth sub-anode 224, in which every two sub-anodes 22 are adjacent, in the first light-emitting device LD1.

On the basis of improving the display effect of the display substrate 100, it may also be possible to avoid overlapping between the four sub-anodes 22 in the first light-emitting device LD1 and the repair signal line Repair, and reduce overlapping between the anode of the first light-emitting device LD1 and the repair signal line Repair as much as possible. Thus, when the repair signal line Repair is coupled to the light-emitting device 20 to be repaired, the repair signal line Repair may provide a stable voltage for the light-emitting device 20 to be repaired, thereby achieving the repair of the light-emitting device 20 to be repaired, and improving the manufacturing yield of the display substrate 100.

In some embodiments, as shown in FIGS. 12 and 14B, an orthographic projection of the transition component 12 on the base substrate SUB at least partially overlaps with an orthographic projection of the repair signal line Repair on the base substrate SUB. It can be understood that the orthographic projection of the transition component 12 on the base substrate SUB may partially overlap with the orthographic projection of the repair signal line Repair on the base substrate SUB, or the orthographic projection of the transition component 12 on the base substrate SUB may completely overlap with the orthographic projection of the repair signal line Repair on the base substrate SUB.

In this way, portions of the repair signal line Repair and the transition component 12 at the at least partially overlapping position may form a repair unit, and the repair unit may avoid the anode of the light-emitting device 20. The transition component 12 coupled to the light-emitting device 20 to be repaired may be connected to the repair signal line Repair, so that the repair unit may provide a stable voltage for the light-emitting device 20 to be repaired. Thus, the light-emitting device 20 to be repaired may work normally, which may improve the manufacturing yield of the display substrate 100.

In some examples, the orthographic projection of the transition component 12 on the base substrate SUB partially overlaps with the orthographic projection of the repair signal line Repair on the base substrate SUB.

In this way, portions of the repair signal line Repair and the transition component 12 at the partially overlapping position may form a repair unit, and the repair unit may avoid the anode of the light-emitting device 20. The transition component 12 coupled to the light-emitting device 20 to be repaired may be connected to the repair signal line Repair, so that the repair unit may provide a stable voltage for the light-emitting device 20 to be repaired. Thus, the light-emitting device 20 to be repaired may work normally, which may improve the manufacturing yield of the display substrate 100.

In some examples, the orthographic projection of the transition component 12 on the base substrate SUB completely overlaps with the orthographic projection of the repair signal line Repair on the base substrate SUB. It can be understood that the orthographic projection of the repair signal line Repair on the base substrate SUB can completely cover the orthographic projection of the transition component 12 on the base substrate SUB.

In this way, portions of the repair signal line Repair and the transition component 12 at the overlapping position may form a repair unit, and the repair unit may avoid the anode of the light-emitting device 20. The transition component 12 coupled to the light-emitting device 20 to be repaired may be connected to the repair signal line Repair, so that the repair unit may provide a stable voltage for the light-emitting device 20 to be repaired. Thus, the light-emitting device 20 to be repaired may work normally, which may significantly improve the manufacturing yield of the display substrate 100.

In some examples, as shown in FIG. 14A, when a sub-pixel needs to be repaired due to the defective pixel, a via hole 125 can be provided at the overlapping position of the repair signal line Repair and the transition component 12. For example, the via hole 125 is formed by laser drilling, and the transition component 12 is connected to the repair signal line Repair through the via hole 125. It can be understood that, when a sub-pixel is not defective, there is no need to perform laser drilling on the transition component 12 and the repair signal line Repair, and reference may be made to FIG. 12.

In this way, the light-emitting device 20 to be repaired at the dead pixel may be electrically connected to the repair signal line Repair, and the repair signal line Repair may transmit a repair driving signal to the light-emitting device 20 to be repaired, so as to drive the light-emitting device 20 to be repaired.

For example, the plurality of light-emitting devices include a plurality of normal light-emitting devices and at least one dummy light-emitting device. A pixel circuit for the dummy light-emitting device can be coupled to the repair signal line Repair and the light-emitting device 20 to be repaired. The pixel circuit for the dummy light-emitting device can transmit the repair driving signal to the light-emitting device 20 to be repaired through the repair signal line Repair.

For another example, the repair signal line Repair transmits a repair driving signal of a constant voltage to the light-emitting device 20 to be repaired, so that the light-emitting device 20 to be repaired becomes a dark spot (i.e., does not emit light).

For example, as shown in FIG. 14A, an orthographic projection of a contour of the via hole 125 on the base substrate SUB is non-overlapping with at least a portion of an orthographic projection of the anode of the light-emitting device 20 on the base substrate SUB. It can be understood that the orthographic projection of the contour of the via hole 125 on the base substrate SUB is non-overlapping with a portion of the orthographic projection of the anode of the light-emitting device 20 on the base substrate SUB. Alternatively, the orthographic projection of the contour of the via hole 125 on the base substrate SUB is non-overlapping with the orthographic projection of the anode of the light-emitting device 20 on the base substrate SUB.

For example, the orthographic projection of the contour of the via hole 125 on the base substrate SUB is non-overlapping with at least a portion of an orthographic projection of a contour of the light-emitting opening of the light-emitting device 20 on the base substrate SUB. It can be understood that the orthographic projection of the contour of the via hole 125 on the base substrate SUB is non-overlapping with a portion of the orthographic projection of the contour of the light-emitting opening of the light-emitting device 20 on the base substrate SUB. Alternatively, the orthographic projection of the contour of the via hole 125 on the base substrate SUB is non-overlapping with the orthographic projection of the contour of the light-emitting opening of the light-emitting device 20 on the base substrate SUB.

In this way, the flatness of the anode of the light-emitting device 20 may be ensured.

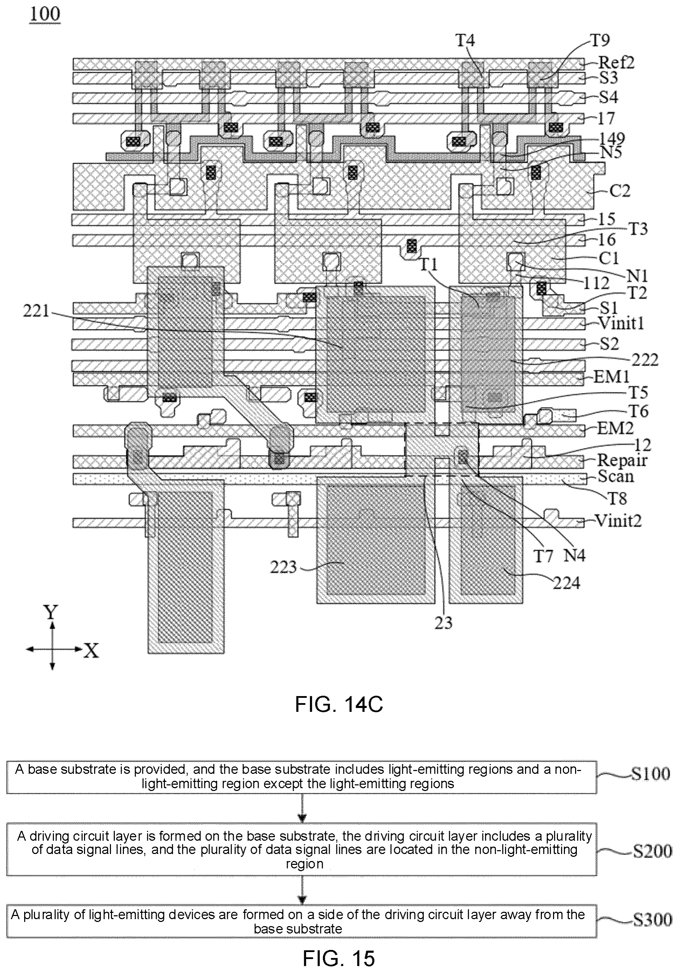

In some examples, as shown in FIG. 14C, an area of the transition component 12 corresponding to the green sub-pixel can be designed to be greater than an area of the transition component 12 corresponding to the red sub-pixel, and the area of the transition component 12 corresponding to the green sub-pixel can be designed to be greater than an area of the transition component 12 corresponding to the blue sub-pixel.

the transition component 12 is connected to the anode of each corresponding sub-pixel; and considering that the luminous efficiency and brightness of the green sub-pixel are relatively high, by making the area of the transition component 12 corresponding to the green sub-pixel relatively large, the area of overlapping between the transition component 12 corresponding to the green sub-pixel and the repair signal line Repair under the transition component 12 is large, thereby increasing the capacitance of a corresponding coupling capacitor at the anode of the green sub-pixel, and achieving the uniform display effect of sub-pixels of various colors.

In some examples, considering other characteristics of the sub-pixel, the area of the transition component 12 corresponding to one of the green sub-pixel, the blue sub-pixel, or the red sub-pixel can be designed to be different from the area of the transition component 12 corresponding to the sub-pixel of another luminous color, so that the area of overlapping between the transition component 12 corresponding to the one of the green sub-pixel, the blue sub-pixel, or the red sub-pixel and the repair signal line Repair under the transition component 12 may be larger or smaller than the area of overlapping between the transition component 12 corresponding to the sub-pixel of another luminous color and the repair signal line Repair under the transition component 12. In this way, the luminous uniformity may be ensured.

In some examples, the display substrate 100 has a normal display region and a special function display region. For example, the special function display region includes a high brightness display region or a low brightness display region. The area of overlapping between the transition component 12 corresponding to the sub-pixel in the normal display region and the repair signal line Repair under the transition component 12 can be designed to be larger or smaller than the area of overlapping between the transition component 12 corresponding to the sub-pixel in the special function display region and the repair signal line Repair under the transition component 12, so that the coupling capacitance of a corresponding anode may be adjusted by the area of overlapping between the transition component 12 and the repair signal line Repair under the transition component 12, thereby further improving the display uniformity.

In some examples, as shown in FIGS. 13 and 14B, in a direction parallel to the base substrate SUB, in the first light-emitting device LD1, an area of a single sub-anode 22 in a part of the sub-anodes 22 is different from an area of a single sub-anode 22 in another part of the sub-anodes 22.

For example, an area of a single sub-anode 22 in a part of the sub-anodes 22 is greater than an area of a single sub-anode 22 in another part of the sub-anodes 22.

The area of a single sub-anode 22 in the first light-emitting device LD1 may be flexibly designed according to actual needs, so that the sub-anode 22 may avoid the data signal line Data or the repair signal line Repair. Thus, the area of overlapping between the data signal line Data and the anode of the first light-emitting device LD1 or between the repair signal line Repair and the anode of the first light-emitting device LD1 may be reduced as much as possible.

In some other examples, in the direction parallel to the base substrate SUB, an area of a single sub-anode 22 in a part of the sub-anodes 22 is the same as an area of a single sub-anode 22 in another part of the sub-anodes 22.

For example, as shown in FIG. 14B, in the first direction X, an area of the first sub-anode 221 is greater than an area of the second sub-anode 222. In the second direction Y, the area of the first sub-anode 221 is equal to an area of the third sub-anode 223.

In some embodiments, as shown in FIGS. 3, 12, and 14B, a light-emitting opening K1 of the first light-emitting device LD1 can include a plurality of light-emitting sub-openings K11. Orthographic projections of the plurality of sub-anodes 22 in the first light-emitting device LD1 on the base substrate SUB cover orthographic projections of contours of the plurality of light-emitting sub-openings K11 on the base substrate SUB, respectively. For example, the light-emitting opening K1 of the first light-emitting device LD1 includes four light-emitting sub-openings K11. The orthographic projections of the four sub-anodes 22 in the first light-emitting device LD1 on the base substrate SUB cover the orthographic projections of contours of the four light-emitting sub-openings K11 on the base substrate SUB, respectively.

An orthographic projection of the pixel defining layer PDL on the base substrate SUB can cover an orthographic projection of the connection portion 23 of the first light-emitting device LD1 on the base substrate SUB. It can be understood that the orthographic projection of the pixel defining layer PDL on the base substrate SUB may overlap with the orthographic projection of the connection portion 23 of the first light-emitting device LD1 on the base substrate SUB.

In this way, the pixel defining layer PDL may provide better support for the light-emitting layer and cathode of the first light-emitting device LD1, thereby improving the flatness of the light-emitting layer and cathode of the first light-emitting device LD1, preventing the direction of light emitted from the light-emitting device 20 from tilting towards the non-light-emitting region FA, and improving the display effect of the display substrate 100.

In some embodiments, as shown in FIG. 14B, the orthographic projection of the connection portion 23 on the base substrate SUB partially overlaps with the orthographic projection of the data signal line Data on the base substrate SUB. An area of the connection portion 23 is less than an area of a single sub-anode 22.

In this way, the area of overlapping between the data signal line Data and the connection portion 23 may be reduced, thereby significantly reducing the parasitic capacitance between the data signal line Data and the anode of the first light-emitting device LD1, improving the stability of the operating voltage of the first light-emitting device LD1, and in turn, improving the display effect of the display substrate 100.

For example, as shown in FIG. 14B, the orthographic projection of the connection portion 23 on the base substrate SUB partially overlaps with the orthographic projection of the repair signal line Repair on the base substrate SUB. An area of the connection portion 23 is less than an area of a single sub-anode 22.

In this way, the area of overlapping between the repair signal line Repair and the connection portion 23 may also be reduced, thereby significantly reducing the parasitic capacitance between the repair signal line Repair and the anode of the first light-emitting device LD1, improving the stability of the voltage transmitted by the repair signal line Repair, and improving the repair effect on the light-emitting device to be repaired.

For example, a shape of the connection portion 23 is H-shaped, rectangular, or polygonal. The connection portion 23 may also have any other shape, so that the area of overlapping between the connection portion 23 and the data signal line Data may be reduced as much as possible, and the area of overlapping between the connection portion 23 and the repair signal line Repair may be reduced as much as possible.

In some embodiments, as shown in FIGS. 13 and 14B, in a light-emitting region EA of at least one light-emitting device 20, a surface of the driving circuit layer 10 close to the light-emitting device 20 is a flat surface. For example, a surface of the fourth conductive layer EC4 close to the light-emitting device 20 is a flat surface.

For example, in a light-emitting region EA of the first light-emitting device LD1, the surface of the driving circuit layer 10 close to the light-emitting device 20 is a flat surface. For example, in a light-emitting region EA of the second light-emitting device LD2, the surface of the driving circuit layer 10 close to the light-emitting device 20 is a flat surface. For another example, in a light-emitting region EA of the third light-emitting device LD3, the surface of the driving circuit layer 10 close to the light-emitting device 20 is a flat surface.

In this way, the surface of the driving circuit layer 10 close to the light-emitting device 20 may flatten the anode of the light-emitting device 20, thereby improving the flatness of the anode of the light-emitting device 20, preventing the direction of light emitted from the light-emitting device 20 from tilting towards the non-light-emitting region FA, and improving the display effect of the display substrate 100.

In some examples, as shown in FIGS. 3, 13, and 14B, the first power supply lines VDD are located on a side of the transition components 12 close to the plurality of light-emitting devices 20. The first power supply line VDD is coupled to the pixel circuit. An orthographic projection of the first power supply line VDD on the base substrate SUB at least partially overlaps with the light-emitting region EA of the light-emitting device 20. It can be understood that, the orthographic projection of the first power supply line VDD on the base substrate SUB partially overlaps with the light-emitting region EA of the light-emitting device 20; or the orthographic projection of the first power supply line VDD on the base substrate SUB covers the light-emitting region EA of the light-emitting device 20.

In the light-emitting region EA, a surface of the first power supply line VDD close to the anode of the light-emitting device 20 is a flat surface.

In this way, the first power supply line VDD may flatten the anode of the light-emitting device 20, thereby improving the flatness of the anode of the light-emitting device 20, preventing the direction of light emitted from the light-emitting device 20 from tilting towards the non-light-emitting region FA, and improving the display effect of the display substrate 100.

For example, in a case where a size of the light-emitting region EA of the first light-emitting device LD1 is greater than a size of the light-emitting region EA of the second light-emitting device LD2, and the size of the light-emitting region EA of the first light-emitting device LD1 is greater than a size of the light-emitting region EA of the third light-emitting device LD3, the orthographic projection of the first power supply line VDD on the base substrate SUB overlaps with the light-emitting region EA of the second light-emitting device LD2 and the light-emitting region EA of the third light-emitting device LD3. It can be understood that the orthographic projection of the first power supply line VDD on the base substrate SUB covers the light-emitting region EA of the second light-emitting device LD2 and the light-emitting region EA of the third light-emitting device LD3.

In this way, in a case where the area of the light-emitting region EA of the first light-emitting device LD1 in the display substrate 100 (i.e., the area of the anode of the first light-emitting device LD1) is relatively large, the first power supply line VDD may at least flatten the anodes of the second light-emitting device LD2 and the third light-emitting device LD3, thereby improving the flatness of the anodes of the second light-emitting device LD2 and the third light-emitting device LD3, preventing the directions of light emitted from the second light-emitting device LD2 and the third light-emitting device LD3 from tilting towards the non-light-emitting region FA, and improving the display effect of the display substrate 100.

For example, in a case where the size of the light-emitting region EA of the first light-emitting device LD1 is greater than the size of the light-emitting region EA of the second light-emitting device LD2, and the size of the light-emitting region EA of the first light-emitting device LD1 is greater than the size of the light-emitting region EA of the third light-emitting device LD3, the orthographic projection of the first power supply line VDD on the base substrate SUB partially overlaps with the light-emitting region EA of the first light-emitting device LD1.

In this way, in a case where the area of the anode of the first light-emitting device LD1 in the display substrate 100 is relatively large, the first power supply line VDD may partially flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

In some examples, as shown in FIG. 14B, the light-emitting region EA of the first light-emitting device LD1 overlaps with an orthographic projection of the second power supply line VSS on the base substrate SUB.

In the light-emitting region EA of the first light-emitting device LD1, a surface of the second power supply line VSS close to the light-emitting device 20 is a flat surface.

In this way, in a case where the area of the anode of the first light-emitting device LD1 is relatively large, the second power supply line VDD may flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

In some embodiments, as shown in FIG. 13, an orthographic projection of the filling block 160 on the base substrate SUB partially overlaps with the orthographic projection of the anode of the first light-emitting device LD1 on the base substrate SUB.

In this way, the filling block 160 may partially flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

In some examples, as shown in FIG. 13, the orthographic projection of the filling block 160 on the base substrate SUB partially overlaps with an orthographic projection of a portion of the anode of the first light-emitting device LD1 on the base substrate SUB. In the light-emitting region EA, a surface of the filling block 160 close to the light-emitting device 20 is a flat surface. For example, the orthographic projection of the filling block 160 on the base substrate SUB partially overlaps with orthographic projections of a portion of the second sub-anode 222 and a portion of the fourth sub-anode 224 on the base substrate SUB.

The orthographic projection of the first power supply line VDD on the base substrate SUB partially overlaps with an orthographic projection of another portion of the anode of the first light-emitting device LD1 on the base substrate SUB. In the light-emitting region EA, a surface of the first power supply line VDD close to the light-emitting device 20 is a flat surface. For example, the orthographic projection of the first power supply line VDD on the base substrate SUB partially overlaps with orthographic projections of another portion of the second sub-anode 222 and another portion of the fourth sub-anode 224 on the base substrate SUB.

In this way, the filling block 160 may flatten a portion of the anode of the first light-emitting device LD1, and the first power supply line VDD may flatten another portion of the anode of the first light-emitting device LD1, which may significantly improve the flatness of the anode of the first light-emitting device LD1, and may prevent the direction of light emitted from the first light-emitting device LD1 from tilting towards the non-light-emitting region FA, thereby significantly improving the display effect of the display substrate 100.

In some embodiments, as shown in FIGS. 13 and 14B, in a light-emitting region EA of at least one light-emitting device 20, a patterned shape of the surface of the driving circuit layer 10 close to the light-emitting device 20 is substantially symmetrical. For example, in a light-emitting region EA of the first light-emitting device LD1, the patterned shape of the surface of the driving circuit layer 10 close to the light-emitting device 20 is substantially symmetrical. For example, in a light-emitting region EA of the second light-emitting device LD2, the patterned shape of the surface of the driving circuit layer 10 close to the light-emitting device 20 is substantially symmetrical. For another example, in a light-emitting region EA of the third light-emitting device LD3, the patterned shape of the surface of the driving circuit layer 10 close to the light-emitting device 20 is substantially symmetrical.

In this way, the surface of the driving circuit layer 10 close to the light-emitting device 20 may symmetrically flatten the anode of the light-emitting device 20, thereby improving the flatness of the anode of the light-emitting device 20, preventing the direction of light emitted from the light-emitting device 20 from tilting towards the non-light-emitting region FA, and improving the display effect of the display substrate 100.

In some examples, as shown in FIGS. 13 and 14B, in the light-emitting region EA, a patterned shape of the first power supply line VDD is substantially symmetrical.

In this way, the first power supply line VDD may symmetrically flatten the anode of the light-emitting device 20, thereby improving the flatness of the anode of the light-emitting device 20, preventing the direction of light emitted from the light-emitting device 20 from tilting towards the non-light-emitting region FA, and improving the display effect of the display substrate 100.

In some examples, as shown in FIGS. 13 and 14B, in the light-emitting region EA of the first light-emitting device LD1, a patterned shape of the second power supply line VSS is substantially symmetrical.

In this way, in a case where the area of the anode of the first light-emitting device LD1 is relatively large, the second power supply line VDD may symmetrically flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

In some examples, as shown in FIG. 13, in the light-emitting region EA, a patterned shape of the filling block 160 is substantially symmetrical.

For example, in the light-emitting region EA of the first light-emitting device LD1, the patterned shape of the filling block 160 is substantially symmetrical.

In this way, the filling block 160 may symmetrically flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

In some embodiments, as shown in FIG. 14B, the first power supply connection line 15 extends in the first direction X, and the first power supply line VDD extends in the second direction Y. The first power supply connection lines 15 are connected to the first power supply lines VDD to form a mesh structure for transmitting the first power supply signal.

The first power supply lines VDD and the first power supply connection lines 15 form the mesh structure for transmitting the first power supply signal on the display substrate 100, which may not only effectively reduce the resistance of the first power supply line VDD and reduce the voltage drop of the first power supply signal, but also effectively improve the uniformity of the first power supply signal in the display substrate 100 and effectively improve the display uniformity.

The second power supply connection line 16 extends in the first direction X, and the second power supply line VSS extends in the second direction Y. The second power supply connection lines 16 are connected to the second power supply lines VSS to form a mesh structure for transmitting the second power supply signal.

The second power supply lines VSS and the second power supply connection lines 16 form the mesh structure for transmitting the second power supply signal on the display substrate 100, which may not only effectively reduce the resistance of the second power supply line VSS and reduce the voltage drop of the second power supply signal, but also effectively improve the uniformity of the second power supply signal in the display substrate 100 and effectively improve the display uniformity.

In some embodiments, as shown in FIGS. 9 and 14B, the orthographic projection of the first power supply line VDD on the base substrate SUB at least partially overlaps with an orthographic projection of the first connection block 149 on the base substrate SUB.

Since the first connection block 149 includes the fifth node N5, the first power supply line VDD with the constant voltage may effectively avoid the influence of other signals in the pixel circuit on the fifth node N5, thereby preventing other signals from affecting the potential of the fifth node N5 of the pixel circuit, and improving the display effect of the display substrate 100.

In some embodiments, as shown in FIGS. 9 and 14B, the orthographic projection of the first power supply line VDD on the base substrate SUB at least partially overlaps with an orthographic projection of the third connection block 112 on the base substrate SUB.

Since the third connection block 112 includes the first node N1, the first power supply line VDD with the constant voltage may effectively avoid the influence of other signals in the pixel circuit on the first node N1, thereby preventing other signals from affecting the potential of the first node N1 of the pixel circuit, and improving the display effect of the display substrate 100.

It should be noted that the first power supply line VDD may be designed with unequal widths. The unequal width design of the first power supply line VDD not only facilitates the layout of the pixel structure but also reduces the parasitic capacitance between the first power supply line VDD and the repair signal line Repair.

In some examples, as shown in FIG. 14B, in the first direction X, a dimension of a portion of the first power supply line VDD that overlaps with the first power supply connection line 15 is greater than a dimension of a portion of the first power supply line VDD that overlaps with the repair signal line Repair. Moreover, the orthographic projection of the first power supply line VDD on the base substrate SUB is non-overlapping with an orthographic projection of the second transition portion 122 on the base substrate SUB.

In this way, on the basis of improving the uniformity of the first power supply signal in the display substrate 100, the first power supply line VDD may be made to avoid the second transition portion 122, which may ensure the repair effect of the repair unit on the light-emitting device 20 to be repaired, and improve the manufacturing yield of the display substrate 100.

In some embodiments, as shown in FIG. 14B, the first reference signal connection line 17 with the main body portion substantially extending in the first direction X is connected to the first reference signal line Ref1 with the main body portion substantially extending in the second direction Y, so that the first reference signal lines Ref1 and the first reference signal connection lines 17 form a mesh structure for transmitting the first reference signal on the display substrate 100.

In this way, the resistance of the first reference signal line Ref1 may be effectively reduced, and the voltage drop of the first reference signal may be reduced; moreover, the uniformity of the first reference signal in the display substrate 100 may be effectively improved, thereby improving the display uniformity.

In some embodiments, as shown in FIG. 14B, on a plane parallel to the base substrate SUB, the first transistor T1, the fourth transistor T4, the fifth transistor T5, the seventh transistor T7, and the ninth transistor T9 can be located between the data signal line Data and the first reference signal line.

In some embodiments, as shown in FIG. 14B, on the plane parallel to the base substrate SUB, the second transistor T2, the sixth transistor T6, and the eighth transistor T8 can be located on a side of the data signal line Data away from the second power supply line VSS.

In summary, in the display substrate 100 provided in the embodiments of the present disclosure, the data signal line Data may avoid the sub-anode 22, and the area of overlapping between the data signal line Data and the anode of the light-emitting device 20 may be reduced as much as possible, thereby reducing the parasitic capacitance between the data signal line Data and the anode of the light-emitting device 20, improving the stability of the operating voltage of the light-emitting device 20, and in turn, improving the display effect of the display substrate 100.

FIGS. 15 to 17 are flowcharts of a manufacturing method for a display substrate, in accordance with some embodiments.

Some embodiments of the present disclosure provide a manufacturing method for a display substrate. The manufacturing method for the display substrate can be performed to obtain the display substrate 100 as described in any of the above embodiments. As shown in FIG. 15, the manufacturing method for the display substrate can include steps S100 to S300.

In step S100, a base substrate SUB is provided. The base substrate SUB includes light-emitting regions EA and a non-light-emitting region FA except the light-emitting regions EA.

For example, a material of the base substrate SUB includes polyethylene terephthalate (PET), polyimide (PI), or cyclo olefin polymer (COP).

The first sub-pixel region P1, the second sub-pixel region P2 and the third sub-pixel region P3 have been described in detail above, and will not be repeated here.

In step S200, a driving circuit layer 10 is formed on the base substrate SUB, and the driving circuit layer 10 includes a plurality of data signal lines Data, and the plurality of data signal lines Data are located in the non-light-emitting region FA.

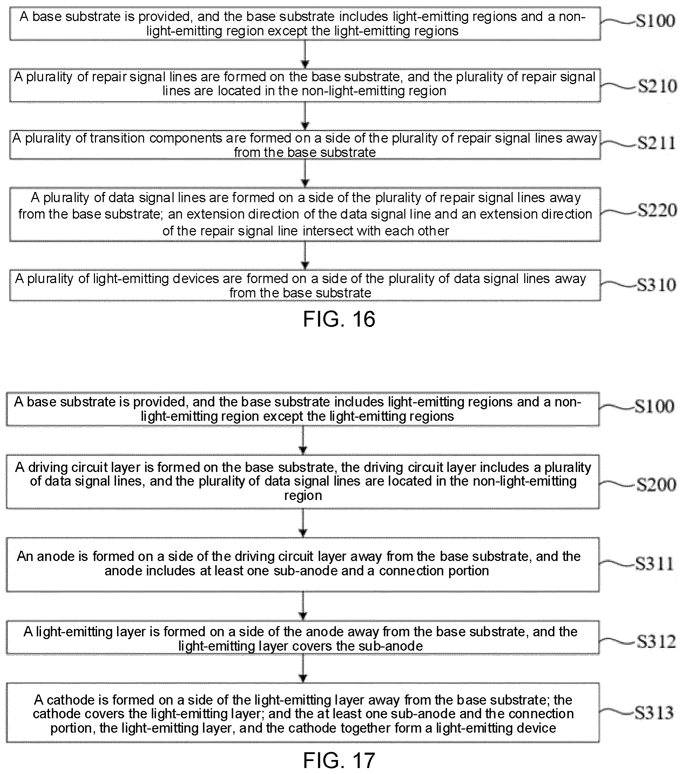

In some examples, as shown in FIG. 16, step S200 includes steps S210 and S220.

In step S210, a plurality of repair signal lines Repair are formed on the base substrate SUB. The plurality of repair signal lines Repair are located in the non-light-emitting region FA.

For example, step S210 includes: forming a metal material layer on the base substrate SUB by using a deposition process; then removing a portion of the metal material layer located in the light-emitting regions EA by using a mask and an etching process, and forming the plurality of repair signal lines Repair through retaining a portion of the metal material layer located in the non-light-emitting region FA.

For example, step S210 may include: sequentially forming a semiconductor layer POLY, a first conductive layer EC1 and a second conductive layer EC2 on the base substrate SUB.

For the specific processes of forming the first conductive layer EC1 and the second conductive layer EC2, reference may be made to the above-mentioned process of forming the plurality of repair signal lines Repair, which will not be described in detail here. The second conductive layer EC2 may include the plurality of repair signal lines Repair located in the non-light-emitting region FA.

In this way, the repair signal line Repair may be coupled to the light-emitting device 20 to be repaired, so that the repair signal line Repair may provide a stable voltage for the light-emitting device 20 to be repaired, thereby achieving the repair of the light-emitting device 20 to be repaired, and improving the manufacturing yield of the display substrate 100.

The specific structures of the semiconductor layer POLY, the first conductive layer EC1 and the second conductive layer EC2 have been described in detail above, which will not be repeated here.

For example, step S210 may further include: forming an insulating layer covering the semiconductor layer POLY. The insulating layer is provided with via holes therein. A material of the insulating layer may be any one or a combination of an oxide, a nitride or an oxynitride, which is not limited here.

For example, an insulating material layer covering the semiconductor layer POLY is formed on the base substrate SUB by using a deposition process; then portions of the insulating material layer are removed by using an etching process to form the via holes, and the remaining portion of the insulating material layer is used as the first insulating layer. An orthographic projection of a contour of the via hole on the base substrate SUB overlaps with an orthographic projection of an active layer of a transistor on the base.

For example, after forming the first conductive layer EC1, the step may further include: forming a second insulating layer. The second insulating layer is located between the first conductive layer EC1 and the second conductive layer EC2. The material of the second insulating layer may be similar to that of the first insulating layer. The manufacturing method of the second insulating layer may refer to the manufacturing method of the first insulating layer, which will not be described in detail here.

In some examples, as shown in FIG. 8, the repair signal line Repair includes repair blocks 123. In a direction (i.e., the second direction Y) perpendicular to an extension of the repair signal line Repair, a dimension of the repair block 123 (a width of the repair block 123) is greater than a dimension of the repair signal line Repair. The repair blocks 123 and the repair signal line Repair can be connected to each other to form a one-piece structure.

In this way, an area of the repair signal line Repair may be relatively large, so that the repair signal line Repair may provide a relatively stable voltage for the light-emitting device 20 to be repaired, which may improve the repair effect on the light-emitting device 20 to be repaired, and in turn, improve the manufacturing yield of the display substrate 100.

For example, the repair signal line Repair is in a shape of a straight line whose main body portion extends in the first direction X.

In some examples, as shown in FIG. 16, after step S210, step S211 may be included.

In step S211, a plurality of transition components 12 are formed on a side of the plurality of repair signal lines Repair away from the base substrate SUB.

For example, step S210 includes: forming a metal material layer on a side of the second conductive layer EC2 away from the base substrate SUB by using a deposition process; then removing a portion of the metal material layer by using a mask and an etching process, and forming the third conductive layer EC3 by the remaining portion of the metal material layer. The third conductive layer EC3 includes the plurality of transition components 12.

It should be noted that the specific structure of the third conductive layer EC3 has been described in detail above and will not be repeated here.

As shown in FIG. 14B, an orthographic projection of the transition component 12 on the base substrate SUB at least partially overlaps with an orthographic projection of the repair signal line Repair on the base substrate SUB. It can be understood that the orthographic projection of the transition component 12 on the base substrate SUB may partially overlap with the orthographic projection of the repair signal line Repair on the base substrate SUB; or the orthographic projection of the transition component 12 on the base substrate SUB may completely overlap with the orthographic projection of the repair signal line Repair on the base substrate SUB.

In this way, portions of the repair signal line Repair and the transition component 12 at the at least partially overlapping position may form a repair unit, and the repair unit may avoid the anode of the light-emitting device 20. The transition component 12 coupled to the light-emitting device 20 to be repaired may be connected to the repair signal line Repair, so that the repair unit may provide a stable voltage for the light-emitting device 20 to be repaired. Thus, the light-emitting device 20 to be repaired may work normally, which may improve the manufacturing yield of the display substrate 100.

Patterned shapes of the plurality of transition components 12 are substantially the same. Repair units may provide a stable voltage for different color light-emitting devices 20 to be repaired, so that the repair units have the same repair effect on the different color light-emitting devices 20 to be repaired, thereby improving the uniformity of the luminous efficiency of the different color light-emitting devices 20 in the display substrate 100.

In some examples, as shown in FIG. 9, the transition component 12 includes a first transition portion 121 and a second transition portion 122. The first transition portion 121 is coupled to the anode of the light-emitting device 20, and the second transition portion 122 is coupled to the repair signal line Repair.

In a direction perpendicular to an extension direction of the repair signal line Repair, a dimension d3 of the second transition portion 122 is greater than a dimension d4 of the first transition portion 121.

In this way, the second transition portion 122 and the repair signal line Repair may form a repair unit. The dimension d3 of the second transition portion 122 is greater than the dimension d4 of the first transition portion 121, so that an area of the repair unit may be large. Thus, the repair unit may provide a relatively stable voltage for the light-emitting device 20 to be repaired, and the repair effect of the repair unit on the light-emitting device 20 to be repaired may be improved, thereby improving the manufacturing yield of the display substrate 100.

For example, a shape of the transition component 12 includes a shape of the Chinese character " 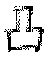 ", a polygon, or any other shape.

For example, after forming the second conductive layer EC2, the method may further include: forming a third insulating layer. The third insulating layer is located between the second conductive layer EC2 and the third conductive layer EC3. The material of the third insulating layer may be similar to that of the first insulating layer. The manufacturing method of the third insulating layer may refer to the manufacturing method of the first insulating layer, which will not be described in detail here.

In step S220, a plurality of data signal lines Data are formed on a side of the plurality of repair signal lines Repair away from the base substrate SUB; and an extension direction of the data signal line Data and an extension direction of the repair signal line Repair intersect with each other. For example, the extension directions of the data signal line Data and the repair signal line Repair are perpendicular to each other.

In some examples, step S220 includes: forming a metal material layer on a side of the third conductive layer EC3 away from the base substrate SUB (i.e., on a surface of a fourth insulating layer away from the base substrate SUB) by using a deposition process; then removing a portion of the metal material layer by using a mask and an etching process, and forming the fourth conductive layer EC4 by the remaining portion of the metal material layer. Thus, the pixel circuit composed of a plurality of transistors and capacitor(s) (e.g., 9T2C) may be formed on the base substrate SUB.

It should be noted that the specific structure of the fourth conductive layer EC4 has been described in detail above and will not be repeated here.

As shown in FIGS. 13 and 14B, the fourth conductive layer EC4 includes the plurality of data signal lines Data located in the non-light-emitting region FA. Forming the plurality of data signal lines Data may include: removing a portion of the metal material layer located in the light-emitting regions EA by using a mask and an etching process, and forming the plurality of data signal lines Data through retaining a portion of the metal material layer located in the non-light-emitting region FA.

For example, the data signal line Data is in a shape of a straight line whose main body portion extends in the second direction Y.

In this way, an area of overlapping between the data signal line Data and the anode of the light-emitting device 20 may be reduced as much as possible, thereby reducing a parasitic capacitance between the data signal line Data and the anode of the light-emitting device 20, improving a stability of an operating voltage of the light-emitting device 20, and in turn, improving the display effect of the display substrate 100.

For example, after forming the third conductive layer EC3, the method may further include: forming the fourth insulating layer. The fourth insulating layer is located between the third conductive layer EC3 and the fourth conductive layer EC4. The material of the fourth insulating layer may be similar to that of the first insulating layer. The manufacturing method of the fourth insulating layer may refer to the manufacturing method of the first insulating layer, which will not be described in detail here.

In some examples, step S220 may further include: forming a plurality of first power supply lines VDD on a side of the plurality of repair signal lines Repair away from the base substrate SUB. After forming the plurality of first power supply lines VDD, in the light-emitting regions EA, a planarization process is performed on surfaces of the plurality of first power supply lines VDD away from the base substrate SUB.

In this way, the first power supply line VDD may flatten the anode of the light-emitting device 20, thereby improving the flatness of the anode of the light-emitting device 20, preventing the direction of light emitted from the light-emitting device 20 from tilting towards the non-light-emitting region FA, and improving the display effect of the display substrate 100.

For example, in the light-emitting region EA, a patterned shape of the first power supply line VDD is substantially symmetrical.

In this way, the first power supply line VDD may symmetrically flatten the anode of the light-emitting device 20, thereby further improving the flatness of the anode of the light-emitting device 20, preventing the direction of light emitted from the light-emitting device 20 from tilting towards the non-light-emitting region FA, and further improving the display effect of the display substrate 100.

In some examples, step S220 may further include: forming a plurality of second power supply lines VSS on a side of the plurality of repair signal lines Repair away from the base substrate SUB. After forming the plurality of second power supply lines VSS, in the light-emitting region EA of the first light-emitting device LD1, a planarization process is performed on a surface of the second power supply line VSS away from the base substrate SUB.

In this way, the second power supply line VSS may flatten the anode of the first light-emitting device LD1, thereby improving the flatness of the anode of the first light-emitting device LD1, preventing the direction of light emitted from the first light-emitting device LD1 from tilting towards the non-light-emitting region FA, and improving the display effect of the display substrate 100.

For example, in the light-emitting region EA of the first light-emitting device LD1, a patterned shape of the second power supply line VSS is substantially symmetrical.

In this way, the second power supply line VSS may symmetrically flatten the anode of the first light-emitting device LD1, thereby further improving the flatness of the anode of the first light-emitting device LD1, preventing the direction of light emitted from the first light-emitting device LD1 from tilting towards the non-light-emitting region FA, and further improving the display effect of the display substrate 100.

The specific structures of the first power supply line VDD and the second power supply line VSS have been described in detail above and will not be repeated here.

In step S300, a plurality of light-emitting devices 20 are formed on a side of the driving circuit layer 10 away from the base substrate SUB.

The specific structure of the plurality of light-emitting devices 20 has been described in detail above and will not be repeated here.

As shown in FIG. 11, the anode of the first light-emitting device LD1 can include a plurality of sub-anodes 22 and a connection portion 23. There is a gap between adjacent sub-anodes 22, and the plurality of sub-anodes 22 are connected to the connection portion 23. For example, the plurality of sub-anodes 22 and the connection portion 23 in the first light-emitting device LD1 are connected to each other to form a one-piece structure.

There is a gap between adjacent sub-anodes 22. It can be understood that, in the first direction X, there is a gap between adjacent sub-anodes 22 in the first light-emitting device LD1; and in the second direction Y, there is also a gap between adjacent sub-anodes 22 in the first light-emitting device LD1.

In some examples, in the plurality of light-emitting devices 20, a size of a light-emitting region EA of the first light-emitting device LD1 is greater than that of a light-emitting region EA of the second light-emitting device LD2, and the size of the light-emitting region EA of the first light-emitting device LD1 is greater than that of a light-emitting region EA of the third light-emitting device LD3. It can be understood that, an area of the anode of the first light-emitting device LD1 is greater than that of the anode of the second light-emitting device LD2, and the area of the anode of the first light-emitting device LD1 is greater than that of the anode of the third light-emitting device LD3.

In some embodiments, as shown in FIG. 14B, an orthographic projection of the data signal line Data on the base substrate SUB is non-overlapping with orthographic projections of the sub-anodes 22 on the base substrate SUB.

In this way, the data signal line Data may avoid the sub-anodes 22, and an area of overlapping between the data signal line Data and the anode of the light-emitting device 20 may be reduced as much as possible, thereby reducing a parasitic capacitance between the data signal line Data and the anode of the light-emitting device 20, improving a stability of an operating voltage of the light-emitting device 20, and in turn, improving the display effect of the display substrate 100.

In some examples, as shown in FIG. 14B, a part of the sub-anodes 22 in the first light-emitting device LD1 is located on a side of the data signal line Data coupled to the first light-emitting device LD1, and another part of the sub-anodes 22 in the first light-emitting device LD1 is located on another side of the data signal line Data coupled to the first light-emitting device LD1. It can be understood that the data signal line Data coupled to the first light-emitting device LD1 is located in the gap between adjacent sub-anodes 22 in the first light-emitting device LD1.

In this way, in a case where the area of the anode of the first light-emitting device LD1 in the display substrate 100 is relatively large, the data signal line Data may avoid the sub-anodes 22 of the first light-emitting device LD1, and the area of overlapping between the data signal line Data and the anode of the first light-emitting device LD1 may be reduced as much as possible, thereby reducing the parasitic capacitance between the data signal line Data and the anode of the first light-emitting device LD1, improving the stability of the operating voltage of the first light-emitting device LD1, and in turn, improving the display effect of the display substrate 100.

In some embodiments, as shown in FIG. 16, step S300 includes step S310.

In step S310, a plurality of light-emitting devices 20 are formed on a side of the plurality of data signal lines Data away from the base substrate SUB.

As shown in FIG. 14B, a part of the sub-anodes 22 in the first light-emitting device LD1 is located on a side of the repair signal line Repair, and another part of the sub-anodes 22 in the first light-emitting device LD1 is located on another side of the repair signal line Repair. It can be understood that, in the second direction Y, the repair signal line Repair can be located in the non-light-emitting region FA between the part of the sub-anodes 22 and the another part of the sub-anodes 22, which are adjacent, in the first light-emitting device LD1.

The repair signal line Repair is arranged in the non-light-emitting region FA between the plurality of sub-anodes 22 in the first light-emitting device LD1, which may avoid overlapping between the plurality of sub-anodes 22 in the first light-emitting device LD1 and the repair signal line Repair, and reduce overlapping between the anode of the first light-emitting device LD1 and the repair signal line Repair as much as possible. Thus, when the repair signal line Repair is coupled to the light-emitting device 20 to be repaired, the repair signal line Repair may provide a stable voltage for the light-emitting device 20 to be repaired, thereby achieving the repair of the light-emitting device 20 to be repaired, and improving the manufacturing yield of the display substrate 100.

In some examples, as shown in FIGS. 11, 13, and 14B, the anode of the first light-emitting device LD1 includes four sub-anodes 22 and one connection portion 23. The connection portion 23 can be located among the four sub-anodes 22 in which every two sub-anodes 22 are adjacent. The four sub-anodes 22 can include a first sub-anode 221, a second sub-anode 222, a third sub-anode 223, and a fourth sub-anode 224. In the first direction X, the first sub-anode 221 and the second sub-anode 222 may be located in a same row, and the third sub-anode 223 and the fourth sub-anode 224 may be located in another row.

The data signal line Data coupled to the first light-emitting device LD1 is located in a gap between the adjacent first sub-anode 221 and second sub-anode 222 in the first light-emitting device LD1 and in a gap between the adjacent third sub-anode 223 and fourth sub-anode 224 in the first light-emitting device LD1.

In this way, in a case where the area of the anode of the first light-emitting device LD1 in the display substrate 100 is relatively large, the data signal line Data may be arranged in the gap between the four sub-anodes 22 in which every two sub-anodes 22 are adjacent. Thus, the area of overlapping between the data signal line Data and the anode of the first light-emitting device LD1 may be reduced to the area of overlapping between the data signal line Data and the connection portion 23, thereby significantly reducing the parasitic capacitance between the data signal line Data and the anode of the first light-emitting device LD1, improving the stability of the operating voltage of the first light-emitting device LD1, and in turn, improving the display effect of the display substrate 100.

The repair signal line Repair can be located between the adjacent first sub-anode 221 and third sub-anode 223 in the first light-emitting device LD1, and between the adjacent second sub-anode 222 and fourth sub-anode 224 in the first light-emitting device LD1. It can be understood that, the repair signal line Repair may be located between the first sub-anode 221, second sub-anode 222, third sub-anode 223, and fourth sub-anode 224, in which every two sub-anodes 22 are adjacent, in the first light-emitting device LD1.

On the basis of improving the display effect of the display substrate 100, it may also be possible to avoid overlapping between the four sub-anodes 22 in the first light-emitting device LD1 and the repair signal line Repair, and reduce overlapping between the anode of the first light-emitting device LD1 and the repair signal line Repair as much as possible. Thus, when the repair signal line Repair is coupled to the light-emitting device 20 to be repaired, the repair signal line Repair may provide a stable voltage for the light-emitting device 20 to be repaired, thereby achieving the repair of the light-emitting device 20 to be repaired, and improving the manufacturing yield of the display substrate 100.

In some examples, as shown in FIGS. 13 and 14B, in a direction parallel to the base substrate SUB, in the first light-emitting device LD1, an area of a single sub-anode 22 in a part of the sub-anodes 22 is different from an area of a single sub-anode 22 in another part of the sub-anodes 22.

For example, an area of a single sub-anode 22 in a part of the sub-anodes 22 is greater than an area of a single sub-anode 22 in another part of the sub-anodes 22.

The area of a single sub-anode 22 in the first light-emitting device LD1 may be flexibly designed according to actual needs, so that the sub-anode 22 may avoid the data signal line Data or the repair signal line Repair. Thus, the area of overlapping between the data signal line Data and the anode of the first light-emitting device LD1 or between the repair signal line Repair and the anode of the first light-emitting device LD1 may be reduced as much as possible.

In some other examples, in the direction parallel to the base substrate SUB, an area of a single sub-anode 22 in a part of the sub-anodes 22 is the same as an area of a single sub-anode 22 in another part of the sub-anodes 22.

For example, as shown in FIG. 14B, in the first direction X, an area of the first sub-anode 221 is greater than an area of the second sub-anode 222. In the second direction Y, the area of the first sub-anode 221 is equal to an area of the third sub-anode 223.

For example, a shape of the sub-anode 22 is rectangular, trapezoidal, or polygonal. The sub-anode 22 may also have any other shape that is convenient for exposing key signal line(s).

In some examples, as shown in FIG. 14B, an orthographic projection of the connection portion 23 on the base substrate SUB partially overlaps with an orthographic projection of the data signal line Data on the base substrate SUB. An area of the connection portion 23 is less than an area of a single sub-anode 22.

In this way, the area of overlapping between the data signal line Data and the connection portion 23 may be reduced, thereby significantly reducing the parasitic capacitance between the data signal line Data and the anode of the first light-emitting device LD1, improving the stability of the operating voltage of the first light-emitting device LD1, and in turn, improving the display effect of the display substrate 100.

For example, as shown in FIG. 14B, the orthographic projection of the connection portion 23 on the base substrate SUB partially overlaps with the orthographic projection of the repair signal line Repair on the base substrate SUB. An area of the connection portion 23 is less than an area of a single sub-anode 22.

In this way, the area of overlapping between the repair signal line Repair and the connection portion 23 may also be reduced, thereby significantly reducing the parasitic capacitance between the repair signal line Repair and the anode of the first light-emitting device LD1, improving the stability of the voltage transmitted by the repair signal line Repair, and improving the repair effect on the light-emitting device to be repaired.

For example, a shape of the connection portion 23 is H-shaped, rectangular, or polygonal. The connection portion 23 may also have any other shape, so that the area of overlapping between the connection portion 23 and the data signal line Data may be reduced as much as possible, and the area of overlapping between the connection portion 23 and the repair signal line Repair may be reduced as much as possible.

In some examples, as shown in FIG. 17, forming a light-emitting device in step S300 includes steps S311 to S313.

In step S311, an anode AE is formed on a side of the driving circuit layer 10 away from the base substrate SUB, and the anode AE includes at least one sub-anode 22 and a connection portion 23.

For example, before step S311, the method may include: forming an insulating layer INL on the side of the driving circuit layer 10 away from the base substrate SUB. Then, the anode AE is formed on a side of the insulating layer INL away from the base substrate SUB. Afterwards, a pixel defining layer PDL is formed on the side of the insulating layer INL away from the base substrate SUB. The pixel defining layer PDL includes a plurality of light-emitting openings.

In some embodiments, as shown in FIGS. 3, 12, and 14B, a light-emitting opening K1 of the first light-emitting device LD1 can include a plurality of light-emitting sub-openings K11. Orthographic projections of the plurality of sub-anodes 22 in the first light-emitting device LD1 on the base substrate SUB cover orthographic projections of contours of the plurality of light-emitting sub-openings K11 on the base substrate SUB, respectively. For example, the light-emitting opening K1 of the first light-emitting device LD1 includes four light-emitting sub-openings K11. The orthographic projections of the four sub-anodes 22 in the first light-emitting device LD1 on the base substrate SUB cover the orthographic projections of contours of the four light-emitting sub-openings K11 on the base substrate SUB, respectively.

An orthographic projection of the pixel defining layer PDL on the base substrate SUB can cover the orthographic projection of the connection portion 23 of the first light-emitting device LD1 on the base substrate SUB. It can be understood that the orthographic projection of the pixel defining layer PDL on the base substrate SUB may overlap with the orthographic projection of the connection portion 23 of the first light-emitting device LD1 on the base substrate SUB.

In this way, the pixel defining layer PDL may provide better support for the light-emitting layer and cathode of the first light-emitting device LD1, thereby improving the flatness of the light-emitting layer and cathode of the first light-emitting device LD1, preventing the direction of light emitted from the light-emitting device 20 from tilting towards the non-light-emitting region FA, and improving the display effect of the display substrate 100.

In step S312, a light-emitting layer EL is formed on a side of the anode AE away from the base substrate SUB, and the light-emitting layer EL covers the sub-anode 22.

In step S313, a cathode CE is formed on a side of the light-emitting layer EL away from the base substrate SUB; the cathode CE covers the light-emitting layer EL; and the at least one sub-anode 22 and the connection portion 23, the light-emitting layer EL, and the cathode CE together form a light-emitting device 20.

For example, the light-emitting device 20 is an OLED, or the light-emitting device 20 is a QLED.

In summary, in the display substrate 100 manufactured by the manufacturing method for the display substrate provided in the embodiments of the present disclosure, the data signal line Data may avoid the sub-anode 22, and the area of overlapping between the data signal line Data and the anode of the light-emitting device 20 may be reduced as much as possible, thereby reducing the parasitic capacitance between the data signal line Data and the anode of the light-emitting device 20, improving the stability of the operating voltage of the light-emitting device 20, and in turn, improving the display effect of the display substrate 100.

The foregoing descriptions are merely specific implementations of the present disclosure, but the protection scope of the present disclosure is not limited thereto, any changes or replacements that a person skilled in the art could conceive of within the technical scope of the present disclosure shall be included in the protection scope of the present disclosure. Therefore, the protection scope of the present disclosure should be determined by the protection scope of the claims.

## Claims

1. A display substrate, comprising:
a base substrate including light-emitting regions and a non-light-emitting region except the light-emitting regions;
a driving circuit layer located on a side of the base substrate, wherein the driving circuit layer includes a plurality of data signal lines, and the plurality of data signal lines are located in the non-light-emitting region; and
a plurality of light-emitting devices located on a side of the driving circuit layer away from the base substrate, wherein
the plurality of light-emitting devices include first light-emitting devices; an anode of a first light-emitting device includes a plurality of sub-anodes and a connection portion, a gap exists between adjacent sub-anodes, and the plurality of sub-anodes are connected to the connection portion; and an orthographic projection of a data signal line on the base substrate is non-overlapping with orthographic projections of the sub-anodes on the base substrate.

2. The display substrate according to claim 1, wherein the plurality of light-emitting devices further include second light-emitting devices and third light-emitting devices; a size of a light-emitting region of the first light-emitting device is greater than a size of a light-emitting region of a second light-emitting device, and the size of the light-emitting region of the first light-emitting device is greater than a size of a light-emitting region of a third light-emitting device; and
a part of the sub-anodes in the first light-emitting device is located on a side of a data signal line coupled to the first light-emitting device, and another part of the sub-anodes in the first light-emitting device is located on another side of the data signal line coupled to the first light-emitting device.

3. The display substrate according to claim 1 or 2, wherein an orthographic projection of the connection portion on the base substrate partially overlaps with an orthographic projection of the data signal line on the base substrate; and
an area of the connection portion is less than an area of a single sub-anode.

4. The display substrate according to claim 2 or 3, wherein in a direction parallel to the base substrate, in the first light-emitting device, an area of a single sub-anode in the part of the sub-anodes is greater than an area of a single sub-anode in the another part of the sub-anodes.

5. The display substrate according to any one of claims 1 to 4, wherein the driving circuit layer further includes a plurality of repair signal lines; the plurality of repair signal lines are located between the base substrate and the plurality of data signal lines, and the plurality of repair signal lines are located in the non-light-emitting region; and an extension direction of the repair signal lines intersects with an extension direction of the data signal lines.

6. The display substrate according to claim 5, wherein a part of the sub-anodes in the first light-emitting device is located on a side of a repair signal line, and another part of the sub-anodes in the first light-emitting device is located on another side of the repair signal line.

7. The display substrate according to claim 6, wherein the anode of the first light-emitting device includes four sub-anodes and one connection portion, and the connection portion is located among the four sub-anodes in which every two sub-anodes are adjacent; and the four sub-anodes include a first sub-anode, a second sub-anode, a third sub-anode, and a fourth sub-anode;
a data signal line coupled to the first light-emitting device is located in a gap between the first sub-anode and the second sub-anode that are adjacent in the first light-emitting device and in a gap between the third sub-anode and the fourth sub-anode that are adjacent in the first light-emitting device; and
the repair signal line is located in a gap between the first sub-anode and the third sub-anode that are adjacent in the first light-emitting device, and in a gap between the second sub-anode and the fourth sub-anode that are adjacent in the first light-emitting device.

8. The display substrate according to any one of claims 5 to 7, wherein the driving circuit layer further includes a plurality of pixel circuits and a plurality of transition components; a pixel circuit is coupled to the data signal line and a transition component, and the pixel circuit is coupled to a light-emitting device through the transition component;
wherein an orthographic projection of the transition component on the base substrate at least partially overlaps with an orthographic projection of a repair signal line on the base substrate.

9. The display substrate according to claim 8, wherein the transition component includes a first transition portion and a second transition portion; the first transition portion is coupled to an anode of the light-emitting device, and the second transition portion is coupled to the repair signal line; and
in a direction perpendicular to an extension direction of the repair signal line, a dimension of the second transition portion is greater than a dimension of the first transition portion.

10. The display substrate according to claim 8 or 9, wherein patterned shapes of the plurality of transition components coupled to the plurality of light-emitting devices are substantially same.

11. The display substrate according to any one of claims 8 to 10, wherein the driving circuit layer further includes a plurality of first power supply lines, and the plurality of first power supply lines are located on a side of the transition components close to the plurality of light-emitting devices; a first power supply line is coupled to the pixel circuit, and an orthographic projection of the first power supply line on the base substrate at least partially overlaps with a light-emitting region of the light-emitting device; and
in the light-emitting region, a surface of the first power supply line close to the light-emitting device is a flat surface; and/or in the light-emitting region, a patterned shape of the first power supply line is substantially symmetrical.

12. The display substrate according to claim 11, wherein the orthographic projection of the first power supply line on the base substrate overlaps with a light-emitting region of a second light-emitting device and a light-emitting region of a third light-emitting device.

13. The display substrate according to claim 11 or 12, wherein the driving circuit layer further includes a plurality of second power supply lines, a plurality of first power supply connection lines, and a plurality of second power supply connection lines; and the plurality of second power supply lines are coupled to the plurality of light-emitting devices;
the first power supply connection lines extend in a first direction, and the first power supply lines extend in a second direction; the plurality of first power supply connection lines are connected to the plurality of first power supply lines to form a mesh structure for transmitting a first power supply signal; and the first direction and the second direction intersect each other; and
the second power supply connection lines extend in the first direction, and the second power supply lines extend in the second direction; and the plurality of second power supply connection lines are connected to the plurality of second power supply lines to form a mesh structure for transmitting a second power supply signal.

14. The display substrate according to any one of claims 1 to 13, wherein in a light-emitting region of at least one light-emitting device, a surface of the driving circuit layer close to the light-emitting device is a flat surface.

15. The display substrate according to any one of claims 1 to 14, wherein in a light-emitting region of at least one light-emitting device, a patterned shape of a surface of the driving circuit layer close to the light-emitting device is substantially symmetrical.

16. The display substrate according to any one of claims 11 to 15, wherein the driving circuit layer further includes filling blocks; a filling block is located between a data signal line coupled to the first light-emitting device and the first power supply line; and an extension direction of the filling block is substantially parallel to an extension direction of the data signal line;
an orthographic projection of the filling block on the base substrate partially overlaps with an orthographic projection of a portion of the anode of the first light-emitting device on the base substrate;
the orthographic projection of the first power supply line on the base substrate partially overlaps with an orthographic projection of another portion of the anode of the first light-emitting device on the base substrate; and
in the light-emitting region, a surface of the filling block close to the light-emitting device is a flat surface; and/or in the light-emitting region, a patterned shape of the filling block is substantially symmetrical.

17. The display substrate according to any of claims 1 to 16, further comprising:
a pixel defining layer located on the side of the driving circuit layer away from the base substrate, wherein the pixel defining layer includes a plurality of light-emitting openings; the plurality of light-emitting devices cover the plurality of light-emitting openings, respectively; a light-emitting opening of the first light-emitting device includes a plurality of light-emitting sub-openings; orthographic projections of the plurality of sub-anodes in the first light-emitting device on the base substrate cover orthographic projections of contours of the plurality of light-emitting sub-openings on the base substrate, respectively; and
an orthographic projection of the pixel defining layer on the base substrate covers an orthographic projection of the connection portion of the first light-emitting device on the base substrate.

18. The display substrate according to any one of claims 1 to 17, wherein the driving circuit layer further includes a plurality of enable signal lines, and the plurality of enable signal lines are coupled to the plurality of light-emitting devices; and an orthographic projection of an enable signal line coupled to a light-emitting device on the base substrate is non-overlapping with the orthographic projections of the sub-anodes on the base substrate.

19. A manufacturing method for a display substrate, the method comprising:
providing a base substrate, wherein the base substrate includes light-emitting regions and a non-light-emitting region except the light-emitting regions;
forming a driving circuit layer on the base substrate, wherein the driving circuit layer includes a plurality of data signal lines, and the plurality of data signal lines are located in the non-light-emitting region; and
forming a plurality of light-emitting devices on a side of the driving circuit layer away from the base substrate, wherein the plurality of light-emitting devices include first light-emitting devices; an anode of a first light-emitting device includes a plurality of sub-anodes and a connection portion, a gap exists between adjacent sub-anodes, and the plurality of sub-anodes are connected to the connection portion; and an orthographic projection of a data signal line on the base substrate is non-overlapping with orthographic projections of the sub-anodes on the base substrate.

20. A display apparatus, comprising:
a circuit board; and
the display substrate according to any one of claims 1 to 18, wherein the display substrate is located on a side of the circuit board and is coupled to the circuit board.
